# EUROPEAN PATENT SPECIFICATION

(11) **EP 4 261 806 B1**
(45) Date of publication and mention of the grant of the patent: **26.11.2025**
(21) Application number: 22901487.3
(22) Date of filing: 13.07.2022
(51) Int. Cl.: G09B 9/00, G09B 19/24, G09B 5/02, H01M 4/04, H01M 10/04, B65H 35/02

(54) **SLITTER SIMULATION APPARATUS AND METHOD FOR SECONDARY BATTERY PRODUCTION**
SPALTERSIMULATIONSVORRICHTUNG UND VERFAHREN ZUR HERSTELLUNG EINER SEKUNDÄRBATTERIE
APPAREIL DE SIMULATION DE REFENDEUSE ET PROCÉDÉ DE PRODUCTION DE BATTERIES SECONDAIRES

(30) Priority: 30.11.2021 KR 20210169415
(43) Date of publication of application: 18.10.2023
(73) Proprietor: LG Energy Solution, Ltd., Seoul 07335 (KR)
(72) Inventor: JO, Gyeong Yun, Daejeon 34122 (KR); KIM, Han Seung, Daejeon 34122 (KR); KIM, Youngduk, Daejeon 34122 (KR); KIM, Nam Hyuck, Daejeon 34122 (KR); JEON, Su Ho, Daejeon 34122 (KR); JEON, Junhyeok, Daejeon 34122 (KR); KANG, Shinkyu, Daejeon 34122 (KR); CHO, Sung Nam, Daejeon 34122 (KR)
(74) Representative: BCKIP Part mbB
(86) International application number: PCT/KR2022/010251
(87) International publication number: WO 2023/101126

(56) References cited:
- WO-A1-2021/235911
- CA-A1- 3 103 277
- KR-A- 20120 019 173
- KR-A- 20120 037 650
- KR-B1- 101 253 542
- KR-B1- 101 523 015
- US-A1- 2021 043 011

## Description

### TECHNICAL FIELD

The present invention in particular relates to a slitter simulation device and method for secondary battery production, as well as a non-transitory computer-readable medium, and the following technical description more generally relates to a slitter simulation device and method for training secondary battery production workers.

### BACKGROUND ART

Due to recent growth of the electric vehicle market, demand for development and production of secondary batteries is rapidly increasing. In response to such an increase in demand for secondary batteries, the number of production plants for secondary battery production is also increasing. However, the number of skilled workers for operating such a secondary battery production plant is remarkably insufficient.

On the other hand, in the past, training and education of new workers was conducted by watching and learning skilled workers, but it was difficult to train and educate new workers for a long time due to a busy secondary battery production schedule. In addition, there is an issue in that it is difficult to sufficiently secure skilled workers due to frequent retirement of workers. In addition, even if a worker is trained on a general method of operating a plant, it is not easy for the worker to immediately respond to various types of defect situations that may occur during the operation of the plant.

US 2021/043011 A1 discloses an immersive ecosystem comprising a VR headset configured to display a 3D rendering to a user and sensor(s) configured to measure a user response to dynamic 3D asset(s) in the 3D rendering. The immersive ecosystem further comprises a processor, an AI engine, and a first non-transitory computer-readable storage medium encoded with program code executable for providing the 3D rendering to the VR headset. The AI engine is operably coupled to a second non-transitory computer-readable storage medium configured to store predetermined response values and time values for dynamic 3D assets. The AI engine comprises a third non-transitory computer-readable storage medium encoded with program code executable for receiving the measured user response, comparing the received user response to the predetermined response value at the predetermined time value, based on the comparison, modifying dynamic 3D asset(s), and communicating the modified dynamic 3D asset(s) to the processor for providing within 3D rendering.

CA 3103277 A1 discloses a virtual reality training and evaluation system comprising a visual display device, one or more user input devices, one or more computer processors, a memory, and a network communication device. Computer-executable instructions are stored in the memory and configured to cause the one or more computer processors to execute a virtual reality training program that simulates a virtual environment displayed on the visual display device. A user is typically prompted to complete a task within the virtual environment. The task may be an electrical, gas, or water construction, maintenance, or service task. User interactions with the virtual environment in order to complete the task are received via the one or more user input devices. The user's performance of the task (and related subtasks) is typically monitored and compared to defined evaluation criteria. Thereafter, the user may be provided with an evaluation.

KR101523015B1 describes a system and method for virtual reality simulation, specifically focusing on the virtual testing and inspection of virtual welds. The system is designed for training welders, welding inspectors, educators, and structural and material technology professionals. The system includes a programmable processor-based subsystem that executes coded instructions to produce 3D virtual welds and perform simulated tests, both destructive and non-destructive. The system provides real-time feedback and allows users to manipulate virtual welds using a user interface. The virtual welds can be analyzed for various properties, including pass/fail conditions and defects. The system also includes a teaching mode and a training mode for educational purposes.

KR 20120019173 describes an electrode assembly and a secondary battery, including methods for manufacturing them. The document focuses on improving the thermal stability of the separator and reducing burr generation in the electrode assembly, which can cause short circuits and explosions. The electrode assembly includes a separator between the anode and cathode plates, which are coated with active materials. The document also describes forming mineral coating layers on the side parts of the electrode plates to enhance thermal stability and prevent short circuits. The manufacturing method includes steps for cutting the electrode plates and forming the mineral coating layers using a roll coating device.

WO02021235911A1 describes an electrode, a secondary battery, and methods for manufacturing them. The document aims to prevent the formation of sharp risk-generating parts on electrodes, which can occur due to operation errors or assembly tolerances during the cutting process. The electrode features a chamfered corner design with a flat portion and an inclined portion to minimize damage and detachment of electrode active material. The manufacturing method includes notching and cutting processes, with the use of laser technology to enhance precision.

KR 20120037650 describes a coating training simulator and a coating training service system. The document aims to provide virtual simulation training for painters in various industrial fields such as shipbuilding, plant construction, and nuclear power plant construction. The simulator allows trainees to perform virtual painting using an air-jet spray gun in a realistic 3D environment, measuring coating thickness and providing feedback. The system includes a main system for managing training results and interfacing with users through a communication network.

KR10125354ZB1 describes a method and system for visualizing virtual welding training using virtual reality technology. The document focuses on creating a realistic virtual welding environment for training purposes, including the visualization of welding elements such as base materials, beads, arcs, spatters, and smoke. The system aims to provide a safe and efficient training environment by simulating real-world welding scenarios, reducing material waste, and allowing for repetitive practice. The visualization process involves displaying virtual welding objects, special effects, and bead expressions, enhancing the training experience for users in industries like shipbuilding and heavy industry.

### Disclosure of the Invention

### Technical Goals

The present disclosure provides a slitter simulation device (system) for secondary battery production, a method, , and a non-transitory computer-readable medium in which a computer program is stored for solving the above issues regarding how to improve the production of secondary batteries and reduce loss due to occurrence of defects.

### Technical Solutions

The present invention is implemented in a variety of ways, including a method, an apparatus, or a non-transitory computer-readable medium in which the computer program is stored. In particular, the object of solving the above issues is achieved by the attached independent claims and further embodiments and improvements of the invention are listed in the attached dependent claims. Hereinafter, up to the "brief description of the drawings", expressions like "... aspect according to the invention", "according to the invention", or "the present invention", relate to technical teaching of the broadest embodiment as claimed with the independent claims. Expressions like "implementation", "design", "optionally", "preferably", "scenario", "aspect" or similar relate to further embodiments as claimed, and expressions like "example", "...aspect according to an example", "the disclosure describes", or "the disclosure" describe technical teaching which relates to the understanding of the invention or its embodiments, which, however, is not claimed as such.

According to an aspect according to the invention, the invention provides a slitter simulation device for secondary battery production, including a memory configured to store at least one instruction, and at least one processor configured to execute the at least one instruction stored in the memory to perform operations. The operations may include executing a device operator comprising a 3D slitter associated with secondary battery production and quality information related to quality of a material generated by the 3D slitter, executing a facility operator comprising a plurality of adjustment parameters for determining an operation of the 3D slitter and a plurality of operation buttons for driving the 3D slitter, obtaining at least one of first user behavior information obtained through the device operator, first button manipulation information obtained through the facility operator, or first user condition information obtained through the facility operator, determining the operation of the 3D slitter based on at least one of the first user behavior information, the first button manipulation information, or the first user condition information, and executing the operation of the 3D slitter.

According to an example embodiment, the operations may further include displaying an unwinder operation panel for determining an operation of an unwinder part of the 3D slitter on the facility operator, and displaying a rewinder operation panel for determining an operation of a rewinder part of the 3D slitter on the facility operator.

According to the invention, the operations further include executing a 3D slitter training scenario based on an operation process of the 3D slitter, and optionally executing at least one of user behavior guide display on the device operator, user condition guide display on the facility operator, or button manipulation guide display on the facility operator according to the 3D slitter training scenario, obtaining at least one of the first user behavior information based on the user behavior guide display, the first button manipulation information based on the button manipulation guide display, or the first user condition information based on the user condition guide display, and changing at least one of the device operator or the facility operator based on at least one of the first user behavior information based on the user behavior guide display, the first button manipulation information based on the button manipulation guide display, and the first user condition information based on the user condition guide display.

According to the invention, the 3D slitter training scenario includes an operation preparation training scenario, and optionally an operation training scenario or a quality check training scenario.

According to an example embodiment, the operation training scenario includes at least one of a jumbo roll loading training operation, a jumbo roll replacement training operation, a rewound roll cutting training operation, a lot end training operation, a rewound roll taking out training operation, a rewound roll core loading training operation, or a lot starting training operation.

According to an example embodiment, the quality check training scenario includes at least one of a width measurement training operation, a mismatch measurement training operation, a defective tag quantity checking operation, a folding level checking operation, or a swell level checking operation.

According to an example embodiment, the operation preparation training scenario includes at least one of an inspection training operation, a tension adjustment training operation, an EPC adjustment training operation, an optical sensor location adjustment training operation, a leveling roll adjustment training operation, or an auto labeler adjustment training operation.

According to an example embodiment, the operations may further include determining a training operation of the operation preparation training scenarios of the 3D slitter, and changing at least one of the operation of the 3D slitter or the quality information related to the quality of the material to a first range based on the determined training operation.

According to an example embodiment, when the determined training scenario is the EPC adjustment training operation, the operations may further include changing a coated part width and an uncoated part width of a rewound roll wound on a lane of the 3D slitter to be different from predetermined specification values.

According to an example embodiment, when the determined training scenario is the optical sensor location adjustment training operation, the operations may further include changing an irradiation location of an optical sensor to a location other than a home location formed in a rewound roll core wound on a lane of the 3D slitter.

According to an example embodiment, when the determined training scenario is the leveling roll adjustment training operation, the operations may further include outputting a swell on a surface of an electrode fabric which has passed through the leveling roll.

According to an example embodiment, the operations may further include obtaining at least one of second user behavior information obtained through the device operator, second button manipulation information obtained through the facility operator, or second user condition information obtained through the facility operator, and changing at least one of the operation of the 3D slitter or the quality information related to the quality of the material changed to the first range to a second range based on at least one of the second user behavior information, the second button manipulation information, or the second user condition information.

According to another aspect according to the invention, the invention also provides a slitter simulation method for secondary battery production performed by at least one processor, including executing a device operator comprising a 3D slitter associated with secondary battery production and quality information related to quality of a material generated by the 3D slitter, executing a facility operator comprising a plurality of adjustment parameters for determining an operation of the 3D slitter and a plurality of operation buttons for driving the 3D slitter, obtaining at least one of first user behavior information obtained through the device operator, first button manipulation information obtained through the facility operator, or first user condition information obtained through the facility operator, the operation of the 3D slitter based on at least one of the first user behavior information, the first button manipulation information, and first user condition information, or the executing the operation of the 3D slitter.

According to an example embodiment, the method further includes displaying an unwinder operation panel for determining an operation of an unwinder part of the 3D slitter on the facility operator, and displaying a rewinder operation panel for determining an operation of a rewinder part of the 3D slitter on the facility operator.

According to an the invention, the method further includes executing a 3D slitter training scenario based on an operation process of the 3D slitter, and optionally executing at least one of user behavior guide display on the device operator, user condition guide display on the facility operator, or button manipulation guide display on the facility operator according to the 3D slitter training scenario, obtaining at least one of the first user behavior information based on the user behavior guide display, the first button manipulation information based on the button manipulation guide display, or the first user condition information based on the user condition guide display, and changing at least one of the device operator or the facility operator based on at least one of the first user behavior information based on the user behavior guide display, the first button manipulation information based on the button manipulation guide display, or the first user condition information based on the user condition guide display.

According to the invention, the 3D slitter training scenario includes an operation preparation training scenario, and optionally an operation training scenario or a quality check training scenario.

According to a not claimed embodiment of the method, the operation training scenario includes at least one of a jumbo roll loading training operation, a jumbo roll replacement training operation, a rewound roll cutting training operation, a lot end training operation, a rewound roll taking out training operation, a rewound roll core loading training operation, or a lot starting training operation.

According to a not claimed embodiment of the method, the quality check training scenario includes at least one of a width measurement training operation, a mismatch measurement training operation, a defective tag quantity checking operation, a folding level checking operation, or a swell level checking operation.

According to a not claimed embodiment of the method, the operation preparation training scenario includes at least one of an inspection training operation, a tension adjustment training operation, an EPC adjustment training operation, an optical sensor location adjustment training operation, a leveling roll adjustment training operation, or an auto labeler adjustment training operation.

According to a not claimed embodiment of the method, the method further includes determining a training operation of the operation preparation training scenario of the 3D slitter, and changing at least one of the operation of the 3D slitter or the quality information related to the quality of the material to a first range based on the determined training operation.

According to a not claimed embodiment of the method, when the determined training scenario is the EPC adjustment training operation, the changing of the at least one of the operation of the 3D slitter or the quality information related to the quality of the material to the abnormal range based on the determined training operation includes changing a coated part width and an uncoated part width of a rewound roll wound on a lane of the 3D slitter to be different from predetermined specification values.

According to a not claimed embodiment of the method, when the determined training scenario is the optical sensor location adjustment training operation, the changing of the at least one of the operation of the 3D slitter or the quality information related to the quality of the material to the abnormal range based on the determined training operation includes changing an irradiation location of an optical sensor to a location other than a home location formed in a rewound roll core wound on a lane of the 3D slitter.

According to a not claimed embodiment of the method, when the determined training scenario is the leveling roll adjustment training operation, the changing of the at least one of the operation of the 3D slitter or the quality information related to the quality of the material to the abnormal range based on the determined training operation includes outputting a swell on a surface of an electrode fabric which has passed through the leveling roll.

According to a not claimed embodiment of the method, the method further includes obtaining at least one of second user behavior information obtained through the device operator, second button manipulation information obtained through the facility operator, or second user condition information obtained through the facility operator, and changing at least one of the operation of the 3D slitter or the quality information related to the quality of the material changed to the first range to a second range based on at least one of the second user behavior information, the second button manipulation information, or the second user condition information.

According to another aspect according to the invention, the invention also provides a non-transitory computer-readable medium for executing the method in accordance with an example embodiment described above on a computer.

### Advantageous Effects

In various example embodiments of the present disclosure, the user performing secondary battery production may perform training associated with an operation method of the secondary battery production apparatus and a condition adjustment method through the simulation device before being put into work, and by training the user in this way, the loss due to the occurrence of defects is remarkably reduced, so that the efficiency of the secondary battery production operation may be effectively improved.

In various example embodiments of the present disclosure, the simulation device may generate and provide a condition adjustment training scenario associated with the malfunction of the secondary battery production apparatus to the user, and accordingly, the user may effectively learn a countermeasure for each situation while solving a malfunction situation that may occur in the real apparatus by himself/herself.

In various example embodiments of the present disclosure, the user may easily learn the operation method of the secondary battery production apparatus through the simulation proceeded step by step according to the job proficiency of the user.

In various example embodiments of the present disclosure, the user may intensively train only a training scenario with a low job proficiency by simply identifying and processing a training scenario lacking training.

The effect of the present disclosure is not limited to the above-mentioned effects, and other effects not mentioned will be apparent to those of ordinary skill in the art (referred to as "those skilled in the art") from the description of the claims.

In the following description, features which in the above summary of the invention have been marked as "not claimed" or "according to the invention" are also hereinafter, when they are described and explained with reference to the drawings, to be understood as "not claimed" or "not part of the invention" or "according to the invention". Even if sometimes in the description of the embodiments below, features marked above "according to the invention" or "the invention" are referred to in connection with the words "can" or "may" or other expressions which contain the notion of them being "optional", it should be understood that indeed such features are considered essential to the invention as claimed and not optional.

### BRIEF DESCRIPTION OF DRAWINGS

Embodiments of the present disclosure will be described with reference to the accompanying drawings described below, in which like reference numerals denote like elements, but are not limited thereto.
FIG. 1 is a diagram illustrating an example in which a user uses a simulation device according to an example embodiment.
FIG. 2 is a functional block diagram illustrating an internal configuration of a simulation device according to an example embodiment.
FIG. 3 is a block diagram illustrating an example in which a simulation device operates according to an example embodiment.
FIG. 4 is a diagram illustrating an example of a display screen displayed or output to a device operator according to an example embodiment.
FIG. 5 is a diagram illustrating an example of a display screen displayed or output to a facility operator associated with a 3D slitter according to an example embodiment.
FIG. 6 is a diagram illustrating an example of an edge position control (EPC) adjustment training operation according to an example embodiment.
FIG. 7 is a diagram illustrating an example of an optical sensor location adjustment training operation according to an example embodiment.
FIG. 8 is a diagram illustrating an example of a leveling roll adjustment training operation according to an example embodiment.
FIG. 9 is a diagram illustrating an example in which operation capability information and test results are generated according to an example embodiment.
FIG. 10 is a diagram illustrating an example of a simulation method for secondary battery production according to an example embodiment.
FIG. 11 is a diagram illustrating an example of a simulation method of a slitter for secondary battery production according to an example embodiment.
FIG. 12 is a diagram illustrating an example of a test result calculation method according to an example embodiment.
FIG. 13 is a diagram illustrating an exemplary computing device for performing the above-described method and/or example embodiment, and the like.

### [Explanation of Reference Numerals]

100: Simulation device
110: User
120: Facility operator
130: Device operator

### Best Mode for Carrying Out the Invention

Hereinafter, example embodiments will be described in detail with reference to the accompanying drawings. However, in the following description, if there is a concern of unnecessarily obscuring the gist of the present disclosure, detailed descriptions of well-known functions or configurations will be omitted.

When describing the example embodiments with reference to the accompanying drawings, like reference numerals refer to like components and a repeated description related thereto will be omitted. In addition, in the description of the example embodiments below, overlapping description of the same or corresponding components may be omitted. However, even if description regarding components is omitted, it is not intended that such components are not included in any example embodiment.

Advantages and features of the example embodiments disclosed herein, and methods of achieving them, will become apparent with reference to the example embodiments described below in conjunction with the accompanying drawings. However, the present disclosure is not limited to the example embodiments disclosed below, but may be implemented in various different forms, and the example embodiments are provided merely to fully inform those skilled in the art related to the present disclosure the scope of the disclosure.

Terms used herein will be briefly described, and the disclosed example embodiments will be described in detail. The terms used herein have been selected as currently widely used general terms as possible while considering the functions in the present disclosure, but these may vary depending on the intention, precedent, or emergence of new technology of those of ordinary skill in the relevant field. In addition, in a specific case, there is a term arbitrarily selected by the applicant, and in this case, the meaning will be described in detail in the description of the corresponding disclosure. Therefore, the terms used herein should be defined based on the meaning of the term and the overall contents of the present disclosure, rather than the simple name of the term.

Expressions in the singular herein include plural expressions unless the context clearly dictates the singular. As used herein, the singular forms are intended to include the plural forms as well, unless the context clearly indicates otherwise. As used herein, when a part includes a certain component, this means that other components may be further included, rather than excluding other components, unless otherwise stated.

It will be further understood that the terms "comprises" and/or "comprising," when used in this specification, specify the presence of stated features, integers, steps, operations, elements, components or a combination thereof, but do not preclude the presence or addition of one or more other features, integers, steps, operations, elements, components, and/or groups thereof.

When it is mentioned that one component is "coupled", "combined", "connected", "associated", or "react" to any other component, the particular component may be directly coupled, combined, connected, associated and/or react to another component, but is not limited thereto. For example, there may be one or more intermediate components between a particular component and another component. As used herein, the term "and/or" includes any one and any combination of any two or more of the associated listed items.

Although terms of "first," "second," and the like are used to explain various components, the components are not limited to such terms. For example, a first component may be referred to as a second component, or similarly, the second component may be referred to as the first component within the scope of the present disclosure.

As used herein, a "secondary battery" may refer to a battery made by using a material in which an oxidation-reduction process between an electric current and a material may be repeated several times. For example, to produce a secondary battery, mixing, coating, roll pressing, slitting, notching and drying, lamination, folding and stacking, lamination and stacking, packaging, charging/discharging, degassing, characteristic inspection, etc., may be performed. In this case, separate production equipment (apparatus) for performing each process may be used. Here, each production equipment may be operated according to adjustment parameters and set values set or changed by the user.

As used herein, a "user" may refer to a worker who performs secondary battery production and operates secondary battery production equipment, and may include users training through a simulation device (e.g., a VR-based simulation device) for secondary battery production equipment. In addition, a "user account" is an ID created to use the simulation device or assigned to each user, and the user may log-in on the simulation device using the user account and perform the simulation, but is not limited thereto.

As used herein, an "facility operator", a"device operator" and a "quality checker" are input/output devices included in or associated with the simulator device and/or software programs displayed on an input/output device, and may refer to devices and/or programs that output images, videos, etc., of a 3D model device or the like, or receive various inputs from a user and transmits them to the simulator device.

As used herein, a "3D model device" is a virtual device that implements real secondary battery production equipment, and may operate in such a way that images, videos, animations, etc., of the virtual device are executed, changed and/or corrected according to information input by the user (e.g., user input information and/or user behavior information and/or button manipulation information). In other words, the "operation of the 3D model device" may include an image, video, animation, etc., of a virtual device to be executed, changed and/or corrected. For example, the 3D model device may include a device for performing mixing, coating, roll pressing, slitting, notching and drying, lamination, folding and stacking, lamination and stacking, packaging, charging/discharging, degassing, and characteristic inspection, respectively. Additionally or alternatively, the 3D model device may be implemented as a 2D model device. In other words, in the present disclosure, the 3D model device is not limited to a 3D model, but may include a 2D model. Accordingly, the 3D model device may include terms such as a 2D model device, an animation model device, and a virtual model device.

As used herein, a "user condition information" may include a user input for setting or changing conditions and/or values of at least some of the adjustment parameters, or information generated by a predetermined algorithm based on the user input. In the present disclosure, the user condition information may be input through a plurality of setting value input windows of an unwinder operation panel and a rewinder operation panel of a facility operator.

As used herein, a "button operation information" is information for driving the 3D model device, and may be obtained by a user's touch action on any one of a plurality of operation buttons displayed on the unwinder operation panel and the rewinder operation panel of the facility operator.

As used herein, a "user behavior information" may include a user input such as a touch input, a drag input, a pinch input, a rotation input, etc., performed on at least a partial area of the 3D model device, or may be information generated by an arbitrary algorithm predetermined based on a corresponding user input.

As used herein, a "training scenario" may include a detailed operation scenario for operating the secondary battery production equipment. For example, when the secondary battery production equipment is a slitter, the training scenario may include an operation preparation training scenario and an operation training scenario, and the operation preparation training scenario may include an inspection training and condition adjustment training. In the inspection training, oil supply tank inspection, airshaft pressure gauge, etc, may be trained. In the condition adjustment training, tension adjustment, edge position control (EPC) adjustment, optical sensor location adjustment, leveling roll adjustment, auto labeler adjustment, etc., may be trained. The operation training scenario may train the operation process of the slitter equipment such as jumbo roll loading, jumbo roll replacement, rewound roll cutting, lot end, rewound roll unloading with auto pusher, rewound roll core loading, lot start, etc.

The condition adjustment training scenario may include changing the operation of the 3D model device to a value, condition, or the like for changing the malfunctioning range. For example, among the components of the 3D model device, the EPC, the optical sensor location, the leveling roll, and the operation of the auto labeler may be changed, and the quality information of the material generated from the 3D model device by the components of the 3D model device may be changed. When the operation, quality information, etc., of the 3D model device are corrected to a normal range by the user, it may be determined that the corresponding condition adjustment training scenario is completed.

As used herein, a "mixing process" may be a process of preparing a slurry by mixing an active material, a binder, and other additives with a solvent. For example, a user may determine or adjust the addition ratio of an active material, a conductive material, an additive, a binder, and the like, in order to prepare a slurry of a specific quality. In addition, as used herein, a "coating process" may be a process of applying the slurry on a foil in a certain amount and shape. For example, a user may determine or adjust the die, slurry temperature, etc., of the coater device to achieve a coating having a specific quality, quantity and shape.

As used herein, a "roll pressing process" may be a process in which the coated electrode is passed between two rotating upper and lower rolls and pressed to a certain thickness. For example, the user may determine or adjust the spacing between rolls, etc., in order to maximize the capacity of the cell by increasing the electrode density with the roll pressing process. In addition, as used herein, a "slitting process" may be a process of cutting the electrode to a predetermined width by passing the electrode between two rotating knives. For example, a user may determine or adjust various adjustment parameters to maintain a constant electrode width.

As used herein, a "notching and drying process" may be a process of removing moisture after punching an electrode in a certain shape. For example, a user may determine or adjust the height of cut, length, etc., to perform punching into a certain quality shape. In addition, as used herein, a "lamination process" may be a process of sealing and cutting the electrode and the separator. For example, the user may determine or adjust a value corresponding to the x-axis, a value corresponding to the y-axis, and the like in order to perform cutting of a specific quality.

As used herein, a "packaging process" may be a process of attaching a lead and a tape to an assembled cell and packaging it in an aluminum pouch, and a "degassing process" may be a process of removing and resealing the gas generated inside the cell due to the initial charge/discharge of the packaged cell. In addition, as used herein, an "activation process" may be a process of folding the side wing of the pouch before shipping the cell, and checking characteristics such as thickness, weight, and insulation voltage of the cell using a measuring device. In the case of such a process, a user may adjust conditions, values, etc., of various adjustment parameters so that each process may be performed with a specific quality within a normal range, or may change a set value corresponding to the device.

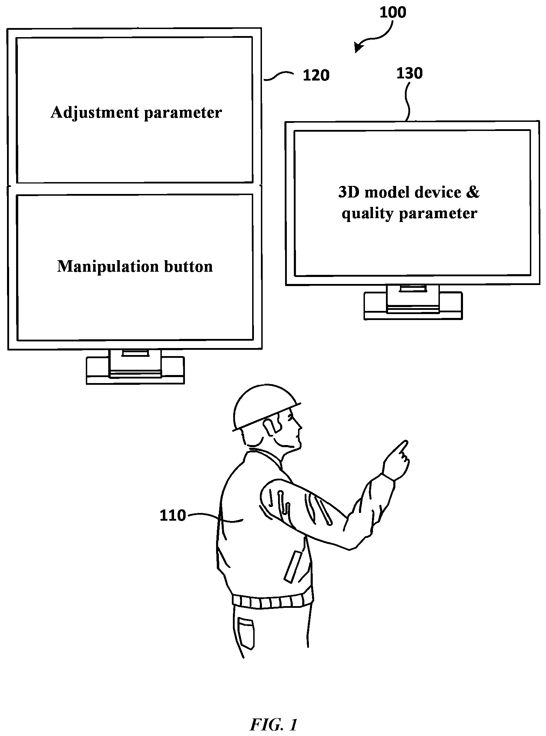

FIG. 1 is a diagram illustrating an example in which a user 110 uses a simulation device 100 according to an example embodiment. As shown, the simulation device 100 is a device for training a secondary battery production worker (e.g., user 110), and may include a facility operator 120 and a device operator 130, etc. For example, the user 110 may learn how to use the secondary battery production equipment by manipulating the simulation device 100 in which the actual secondary battery production equipment is virtualized (e.g., 2D, 3D).

According to an example embodiment, the facility operator 120 may include a plurality of adjustment parameters and manipulation buttons for determining the operation of the 3D model device displayed on the device operator 130, and the user 100 may change the condition of at least some of the adjustment parameters or touch the manipulation button to execute, change, and/or correct the operation of the 3D model device. In other words, the operation of the 3D model device may be adaptively changed or corrected by a change in the adjustment parameter input by the user 110.

The facility operator 120 may be changed into an unwinder operation panel and a rewinder operation panel by a touch manipulation of an icon displayed on the device operator 130. The unwinder operation panel may include a plurality of set value input windows and a plurality of manipulation buttons for executing, changing and/or correcting the operation of the unwinder part of the slitter. The rewinder operation panel may include a plurality of set value input windows and a plurality of manipulation buttons for executing, changing and/or correcting the operation of the rewinder part of the slitter.

The device operator 130 may include a 3D model device associated with the production of secondary batteries. Here, the 3D model device may include a 3D model associated with the secondary battery production equipment, such as a mixer, a coater, a slitter, a roll press, a lamination device, and a L&S (lamination & stack) device, but is not limited to, and may include a 3D model of any other device used for the production of secondary batteries. According to an example embodiment, the user 110 may perform a touch input, a drag input, a pinch input, etc., with respect to the 3D model device (at least a partial area of the 3D model device) included in the device operator 130 to manipulate the 3D model device or change the configuration of the 3D model device. The user 110 may check or enlarge/reduce an arbitrary area of the 3D model device through view switching, etc., and may perform a touch input, etc., to manipulate the 3D model device or change the configuration of the 3D model device. Here, although it has been described above that the device operator 130 displays a 3D model device associated with secondary battery production, it is not limited thereto, and a device associated with a specific process according to the secondary battery production process be implemented as a 2D model device and displayed.

The device operator 130 may include quality information associated with a malfunction of the 3D model device and the quality of a material generated by the 3D model device. Here, the quality information may be generated by performing an operation on a quality parameter, etc., based on a predetermined criterion and/or an algorithm. In other words, in response to changing adjustment parameters or manipulating buttons and/or 3D model devices, the user 110 may check the operation of the 3D model device and quality information of a material generated by the 3D model device through the device operator 130. Additionally or alternatively, a quality checker separate from the device operator 130 may be independently configured in a specific process according to the secondary battery production process.

The quality information may be displayed in association with the 3D model device of the device operator 130, confirmed by a specific operation of the 3D model device, or additionally displayed on a screen of a partial area of the 3D model device. For example, when a button for quality checking displayed on the device operator 130 is selected, quality information may be displayed or output as a pop-up screen. In another example, the quality information may be displayed or output due to a color change or an alarm of at least a partial area of the 3D model device. In another example, when a malfunction occurs in the operation of the 3D model device or a defect occurs in the material quality produced by the 3D model device, a malfunction/defect occurrence indication may be immediately displayed or output in the area of the device operator 130 corresponding to the malfunction/defect occurrence area of the 3D model device. In another example, the quality information may be displayed or output by changing the color or set value of at least a partial area of the equipment operator and/or the 3D model device.

In FIG. 1, the simulation device 100 is illustrated as including one facility operator 120, but the present disclosure is not limited thereto, and the facility operator 120 may be determined in any number according to the type of the 3D model device associated with the simulation device 100. In addition, although it is shown in FIG. 1 that the device operator 130 of the simulation device 100 also functions as a quality checker, it is not limited thereto, and a quality checker separate from the device operator 130 may be configured independently. With such configuration, the user 110 performing secondary battery production may perform training related to the operation preparation method, the operation method, and the response method when a defect occurs of the secondary battery production apparatus, through the simulation device 100 before being put into work, and by training the user 110 in this way, the user's equipment manipulation skill is increased and loss due to the occurrence of defects is remarkably reduced, so that the efficiency of the secondary battery production operation may be effectively improved.

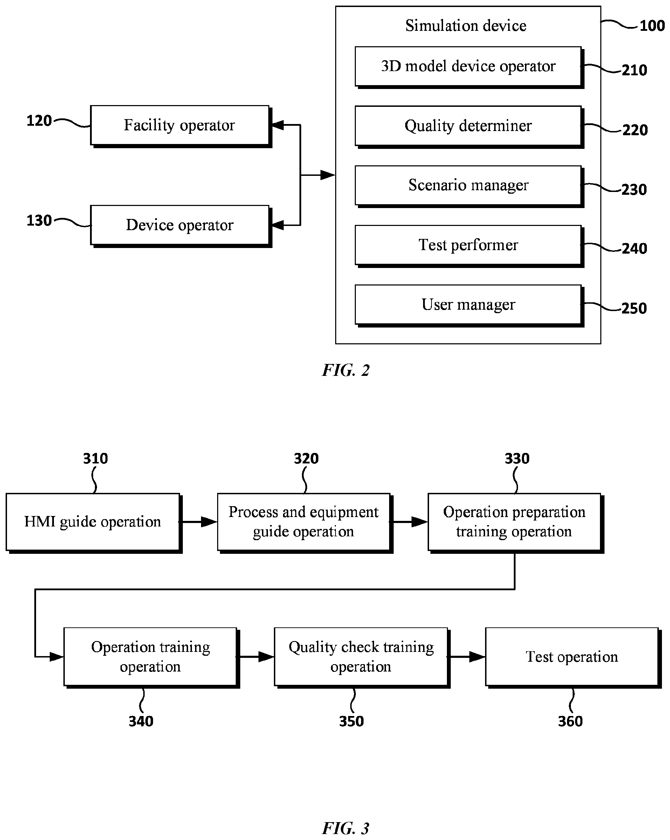

FIG. 2 is a functional block diagram illustrating an internal configuration of a simulation device 100 according to an example embodiment. As shown, the simulation device 100 (e.g., at least one processor of the simulation device 100) may include a 3D model device operator 210, a quality determiner 220, a scenario manager 230, a test performer 240, a user manager 250, etc., but is not limited thereto. The simulation device 100 communicates with the facility operator 120 and the device operator 130, and may exchange data and/or information associated with the 3D model device.

The 3D model device operator 210 may execute, change, and/or correct the operation of the 3D model device displayed on the device operator 130 according to a user's manipulation. In addition, the operation of the facility operator 120 may be executed, changed and/or corrected based on the execution, change and/or correction of the operation of the model device. According to an example embodiment, the 3D model device operator 210 may obtain or receive user behavior information, button manipulation information, and/or user condition information using information input from a user (e.g., a secondary battery production worker). Then, the 3D model device operator 210 may determine or change the operation of the 3D model device using the obtained or received user behavior information, button manipulation information, and/or user condition information.

According to an example embodiment, the user behavior information is information generated based on a user input such as touching and/or dragging at least a partial area of the 3D model device included in the device operator 130, and may include information about a change amount of a set value of the 3D model device according to the user input, and the like. For example, when the 3D model device is a slitter for secondary battery production, the user may release or fix the optical sensor fixing screw by touching the optical sensor fixing screw, drag the optical sensor to move the location, move the leveling roll by clicking or dragging the leveling roll, select a tool for quality check to check the quality, and touch a specific area of the slitter to enlarge or reduce the area. In this case, user behavior information based on a light sensor fixing screw, a light sensor, a leveling roll, a quality check tool, and a specific area may be generated.

According to an example embodiment, the user condition information is information generated based on a user input for changing a condition and/or a value of at least some of the plurality of adjustment parameters included in the facility operator 120, and may include information about a change amount of a condition value for determining an operation of the 3D model device according to a user input. For example, when the 3D model device is a slitter device for secondary battery production, the user may change the EPC location value, the tension value, etc., to a specific value through the facility operator 120, and in this case, user condition information based on the changed EPC location value and tension value may be generated.

According to an example embodiment, the button manipulation information is information generated based on a user input of touching at least some manipulation buttons among a plurality of manipulation buttons included in the unwinder operation panel and the rewinder operation panel, and may include information for driving the 3D model device according to the user input. For example, when the 3D model device is a slitter for secondary battery production, the 'STOP' button may be touched to stop the equipment, and the 'RUN' button may be touched to drive the equipment again, the 'LOW SPEED' button may be touched to drive the low speed equipment, and the 'TENSION ON' and 'TENSION OFF' buttons may be touched respectively to apply or release tension to the rewinder. In each case, button manipulation information based on the touched button may be generated.

As described above, when the operation of the 3D model device is executed based on the user condition information, the button manipulation information, and/or the user behavior information, the quality determiner 220 may determine or generate quality information associated with the quality of the material generated by the operation of the 3D model device. In other words, when the 3D model device operates (when an animation, an image, etc., in which the 3D model device operates), the quality information may be differently determined or generated according to set values and condition values of the corresponding 3D model device. In other words, the user may change or adjust the quality of the material generated by the 3D model device by changing the adjustment parameter or setting at least a partial area of the 3D model device by a touch input or the like.

According to an example embodiment, the quality determiner 220 may determine or extract one or more quality parameters for determining the quality of the material generated by the 3D model device, and while the operation of the 3D model device is executed, may calculate a value corresponding to each of the one or more quality parameters determined based on the operation of the model device. Here, the value corresponding to the quality parameter may be calculated by any predetermined algorithm. In addition, the quality determiner 220 may generate quality information associated with the quality of the material generated by the 3D model device based on values corresponding to each of the one or more quality parameters calculated. For example, when the 3D model device is a slitter for secondary battery production, when the user adjusts the EPC location, a value corresponding to the slitting width for each lane of material may be calculated. In other words, depending on the location of the EPC, the slitting width for each lane may be defective, and by adjusting the EPC location, the defective slitting width for each lane may be resolved. In addition, when the user adjusts the location of the leveling roll, a value corresponding to the surface swell of the coated part of the material may be calculated. In addition, when the user adjusts the location of the optical sensor, a value corresponding to whether the transverse winding is abnormal may be calculated. In this case, the quality determiner 220 may generate or output quality information corresponding to the slitting width, the coated part surface, and the transverse winding.

According to an example embodiment, the 3D model device performs an operation preparation training scenario and an operation scenario, and in the operation preparation training scenario, at least some of the set value, the condition value, and the quality information corresponding thereto of the 3D model device may be changed to an abnormal range. For example, in the case of a slitter, the EPC location value, the optical sensor location, and the location of the leveling roll may be set to an abnormal range.

According to an example embodiment, the scenario manager 230 may determine training scenario among a plurality of operation preparation training scenarios, operation training scenarios, and quality check training scenarios of the 3D model device, and may change at least one of quality information associated with the quality of the material and the operation of the 3D model device based on the determined one or more training scenarios. For example, when the 3D model device is a slitter, the plurality of operation preparation training scenarios may extract at least one of tension adjustment training, EPC adjustment training, optical sensor location adjustment training, leveling roll adjustment training, and auto labeler adjustment training to determine one training scenario, and may change the adjustment parameters, operation, quality information, etc., of the 3D model device according to the extracted or determined training scenario. In addition, the operation training scenario may include jumbo roll putting training, jumbo roll replacement training, rewound roll cutting training, lot end training, rewound roll taking out training, rewound roll core putting training, lot starting training. The quality check training scenario may include width (coated part width and uncoated part width after slitting) measurement training, mismatch (front and back mismatch) measurement training, defective tag quantity check, fold level check, swell level check, etc.

According to an example embodiment, when a training scenario is generated, the user may change the adjustment parameter, change the setting of the 3D model device, or touch the manipulation button to proceed with the generated training scenario. In this case, the scenario manager 230 may receive at least one of user behavior information, button manipulation information, and user condition information for proceeding one or more determined training scenarios, and may change the changed operation of the 3D model device based on at least one of the received user behavior information, button manipulation information, and user condition information. In addition, while the operation of the changed 3D model device is executed, the scenario manager 230 may calculate a value corresponding to each of a plurality of quality parameters associated with the quality of the material generated by the 3D model device based on the operation of the 3D model device being executed, and may correct the quality information associated with the quality of the material generated by the changed 3D model device based on values corresponding to each of the plurality of calculated quality parameters.

Then, the scenario manager 230 may determine whether one or more training scenarios are completed using the corrected quality information. For example, when the quality of the material is within a normal range of a predetermined specification, the scenario manager 230 may determine that the training scenario is completed, but is not limited thereto, and when the value of each quality parameter included in the quality information corresponds to a normal range or a specific value of a predetermined specification, the scenario manager 230 may determine that the training scenario is completed. Additionally or alternatively, when a value calculated by providing each quality parameter to an arbitrary algorithm falls within a predetermined normal range, the scenario manager 230 may determine that the training scenario is completed. For example, in the case that the training scenario is EPC adjustment training of a 3D slitter, when an EPC adjustment training operation is executed, the EPC location value of the jumbo roll is set to an abnormal range, so that the slitting width defect of at least one lane of the material (rewound roll) produced by the 3D slitter occurs, by obtaining user behavior information, button manipulation information, and user condition information input from the user, when the EPC location value is changed to the normal range, the slitting width defect of each lane is resolved, and when the defective slitting width of each lane is resolved as described above, it may be determined that the EPC adjustment trainingEPC adjustment training operation is completed.

According to an example embodiment, the test performer 240 may determine whether one or more training scenarios are completed using the corrected quality information, and when it is determined that one or more training scenarios are completed, may calculate a running time, a loss value, and the like while one or more training scenarios are in progress. For example, the loss value may include a material loss value and the like, and may be calculated through a predetermined algorithm based on a user's response time, a value input by the user, and the like. In addition, the test performer 240 may generate operation capability information for the 3D model device of the user account based on the calculated running time and loss value. Here, the user account may refer to an account of a worker using the simulation device 100, and the operation capability information is information indicating the work skill level of the user, and may include the work speed, the degree of proximity to the target value, the evaluation score, etc. Additionally, when the corresponding user solves all predetermined types of training scenarios, the test performer 240 may determine whether the user passes the simulation training based on operation capability information for each training scenario.

The user manager 250 may perform managing of the registration, modification, deletion, etc., of a user account associated with a user who uses the simulation device 100. According to an example embodiment, the user may use the simulation device 100 using his/her registered user account. In this case, the user manager 250 may store and manage information on whether each training scenario is performed for each user account and operation capability information corresponding to each training scenario in an arbitrary database. Using the information stored by the user manager 250, the scenario manager 230 may extract information associated with a specific user account stored in the database, and may extract and determine at least one of a plurality of training scenarios based on the extracted information. For example, the scenario manager 230 may extract and generate only a training scenario in which the working speed is lower than the average working speed based on the information associated with the user account, or provide it to the user, but is not limited thereto, and the training scenario may be extracted or determined by any other criterion or combination of any criteria.

In FIG. 2, each functional configuration included in the simulation device 100 has been separately described above, which is only to help the understanding of the disclosure, and two or more functions may be performed by one computing device. In addition, in FIG. 2, the simulation device 100 is illustrated as being separated from the facility operator 120 and the device operator 130, but is not limited thereto, and the facility operator 120 and the device operator 130 may be included in the simulation device 100. With such a configuration, the simulation device 100 may generate and provide a training scenario having various values associated with the operation of the secondary battery production equipment to the user, and accordingly, the user may solve each operation situation of the device by himself/herself and learn how to respond effectively to situations.

FIG. 3 is a block diagram illustrating an example in which a simulation device 100 operates according to an example embodiment. As shown, the simulation device (100 in FIG. 1) may operate through a process such as Human-Machine Interface (HMI) guide operation 310, process and equipment guide operation 320, operation preparation training operation 330, operation training operation 340, quality check training operation 350, test operation 360, and the like. In other words, the user may train the manipulation method of the secondary battery production equipment, etc., through operations 310, 320, 330, 340, 350 and 360.

The HMI guide operation 310 may be an operation of learning the types of various adjustment parameters included in the facility operator, and a method of manipulating the adjustment parameters. For example, a work order indicating a type of adjustment parameter, a method of manipulating the adjustment parameter, etc., may be displayed or output on a facility operator, an device operator, and the like. Additionally, a portion of the screen may be turned on or activated so that the user may perform a work corresponding to the work order. In this case, the user may train the use method of the facility operator by manipulating the conditions and/or values of any adjustment parameter corresponding to the work order. When the user touches any button for a predetermined time according to the work order or inputs a correct value corresponding to any parameter, the next operation may be proceeded or a button that may proceed to the next operation (e.g., NEXT button, etc.) may be displayed or activated.

The process and equipment guide operation 320 may be an operation for explaining the secondary battery production process or equipment. When the 3D model device is a slitter, the slitter process description, the description of the unwinder part and its components, the discription of the vision and its components, the description of the knife and its components, and the description of the rewinder part and its components may be included.

The operation preparation training operation 330 may be an operation in which the user learns how to set initial values of the facility operator, the device operator, etc., before operating the secondary battery production apparatus, and may be an operation of learning the quality change of the material generated by the 3D model device according to the value of the adjustment parameter of the facility operator and the state of the device operator.

The operation preparation training operation 330 is a training scenario execution operation based on the operation preparation process of the secondary battery production apparatus, and may include an inspection training operation and a condition adjustment training operation. The inspection training operation may include oil supply tank inspection training and air shaft pressure gauge inspection training. The condition adjustment training operation may include a tension adjustment training, an edge position control (EPC) adjustment training, an optical sensor location adjustment training, a leveling roll adjustment training, and an auto labeler adjustment training. The 3D model device is driven according to the scenario of each training operation, and guide information such as a type of adjustment parameter to be manipulated for checking and adjusting, a value of an adjustment parameter, a manipulation button, a 3D model device, etc., may be displayed or output. In other words, the work order may be displayed or output on the facility operator, the device operator, etc., and a portion of the screen may be turned on or activated so that the user may perform the task corresponding to the work order. In this case, the user may manipulate the facility operator and the device operator corresponding to the work order and input a set value, and when one task is completed, the next operation is proceeded or a button that may proceed to the next operation (e.g., NEXT button, etc.) may be displayed or activated. Accordingly, the user may train the operation preparation process of the slitter for secondary battery production based on the information displayed as described above.

In the condition adjustment training operation of the operation preparation training operation 330, one of the material information related to the operation of the 3D slitter associated with the secondary battery production apparatus and the quality of the material produced by the 3D slitter may be changed to an abnormal range, and may be an operation in which the user learns how to check the abnormal state and correct the abnormal state. For example, in the edge position control (EPC) adjustment training, the slitting width for each lane may be changed to an abnormal range that is out of the specification, in the optical sensor location adjustment training, the transverse winding may be changed to a non-uniform abnormal range, and in leveling roll adjustment training, it may be modified to form a swell on the surface of the coated part of material. In order to solve this abnormal situation, the type of the adjustment parameter to be manipulated, the value of the adjustment parameter, the manipulation button, the driving of the 3D model device, etc., may be displayed or output. The user may train a method of correcting the abnormal range into the normal range based on the displayed information.

The operation training operation 340 is an operation in which the user trains the operation of the 3D slitter, and may include a jumbo roll input training operation, a jumbo roll replacement training operation, a rewound roll cutting training operation, a lot end training operation, a rewound roll takeout training operation, and a rewound roll core input training operation and a lot start training operation.

The quality check training operation 350 may include a width (a coated part width and an uncoated part width after slitting) measurement training operation, a mismatch (the degree of mismatch between the front and the back) measurement training operation, a defective tag quantity checking operation, fold level checking operation, swell level checking operation, and the like.

The 3D model device is driven according to the scenario of each training operation, and guide information such as the type of adjustment parameter to be manipulated for checking and adjusting, the value of the adjustment parameter, the manipulation button, and the 3D model device may be displayed or output. In other words, the work order may be displayed or output on the facility operator, the device operator, etc., and a portion of the screen may be turned on or activated so that the user may perform the task corresponding to the work order. In this case, the user may manipulate the facility operator and the device operator corresponding to the work order and input a set value, and when one task is completed, the next operation is proceeded or a button that may proceed to the next operation (e.g., NEXT button, etc.) may be displayed or activated. Accordingly, the user may train the operation process of the slitter for secondary battery production based on the information displayed as described above.

The test operation 360 may be an operation in which the user's operating capability is evaluated by testing the process in which the user completes the training scenario. For example, when a user completes each training scenario, the operation capability of the corresponding user may be measured or evaluated based on the running time and loss value of each training scenario. The user may additionally learn or train for insufficient training scenarios by checking the operation capability, whether the test has passed, or the like.

In FIG. 3, each operation is illustrated as being sequentially proceeded, but the present disclosure is not limited thereto, and some of the operations may be omitted. In addition, the proceeding order of each operation may be changed or may be repeatedly executed. For example, the operation preparation training operation 330, the operation training operation 340, and the quality check training operation 350 may be performed again after the test operation 360. With such a configuration, the user may easily learn the operation method of the secondary battery production apparatus through the simulation proceeded step by step according to the user's work skill level.

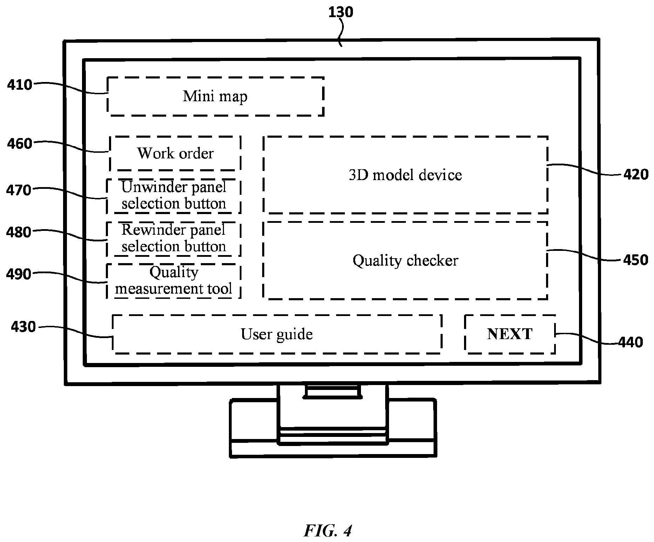

FIG. 4 is a diagram illustrating an example of a display screen displayed or output to a device operator 130 according to an example embodiment. As shown, the device operator 130 may display or output text, an image, a video, etc., including a mini map 410, a 3D model device 420, a user guide 430, a NEXT button 440, a quality checker 450, a work order selection button 460, an unwinder panel selection button 470, a rewinder panel selection button 480, a quality measurement tool selection button 490, and the like on the display screen. In FIG. 4, the mini map 410, the 3D model device 420, the user guide 430, a NEXT button 440, the quality checker 450, the work order selection button 460, the unwinder panel selection button 470, the rewinder panel selection button 480, the quality measurement tool selection button 490, and the like are shown to be displayed in a specific area on the display screen, but are not limited thereto, and each text, image, image, etc., may be displayed in an arbitrary area of the display screen, or may be overlapped.

The mini map 410 schematically displays the entire slitter device for secondary battery production, and displays a schematic location of the area displayed on the 3D model device 420 among the entire slitter device in a rectangular box. When the device displayed on the 3D model device 420 is changed, the location and size of the rectangular box displayed on the mini map 410 may also be changed in real time. For example, this mini map may function as a location guide map of the slitter device.

The 3D model device 420 may be a three-dimensional image, video, or the like in which secondary battery production equipment is implemented in a 3D form. For example, the 3D model device 420 may operate based on user condition information, button manipulation information, and/or user behavior information input from the user.

The user guide 430 includes information necessary to operate the 3D model device 420, user condition information required to solve a training scenario, button manipulation information and user behavior information, and may be information to guide the user's next behavior. In other words, even when the user does not know how to operate the simulation device, the user may use the user guide 430 to train the operation method of the simulation device.

In the case of determining the condition value, set value, etc., of the 3D model device or operating the 3D model device 420 using the displayed user guide 430 or the like, the corresponding operation is solved and the NEXT button 440 for proceeding to the next operation may be activated. The user may select the activated NEXT button 440 by a touch input or the like to perform training corresponding to the next operation.

The quality checker 450 may display or output quality information associated with the quality of the material generated by the 3D slitter. In other words, quality information associated with the quality of the material measured by the quality check tool 490 may be displayed on the quality checker 450. For example, information such as a coated part width and an uncoated part width of each lane of the material produced in the 3D slitter may be displayed as images, graphs, tables, and the like. The quality checker 450 may be displayed or output overlapped on the screen of the 3D model device 420 in a pop-up form. The simulator device (100 in FIG. 1) may determine one or more quality parameters for determining the quality of the material generated by the 3D slitter, and while the operation of the 3D slitter is executed, values corresponding to each of the one or more quality parameters determined based on the executed operation of the 3D slitter may be calculated. Then, the simulation device may generate and output quality information associated with the quality of the material generated by the 3D slitter based on the values corresponding to each of the calculated one or more quality parameters. In the illustrated example, the quality checker may display quality information corresponding to various slitting width defects, and such slitting width defects may be determined by the image, video, animation, etc., of the 3D slitter displayed on the device operator 130, or may be determined by the set value of the adjustment parameter displayed on the facility operator 120. When the adjustment parameter corresponding to the EPC location value displayed on the facility operator 120 is changed, the image, video, animation, etc., of the 3D slitter of the device operator 130 may be changed in response to this, or quality information related to the quality of a material displayed on the quality checker may be changed.

The work order selection button 460 is a button for displaying or outputting the work order on the screen of the device operator 130. The work order is a document including initial set values and condition values of the 3D model device 420, and may be predetermined or generated by an arbitrary algorithm. For example, the simulation device may receive and provide the contents of the work order used to operate the real secondary battery production equipment, or may generate a new work order by calculating initial set values and condition values of the 3D model device 420 based on the plurality of input work orders. The work order may be continuously displayed on the device operator 130, and when the user touch manipulates the work order selection button 460, it may be displayed in a pop-up form on the 3D model device, and then when the user touches the work order selection button 460 again, it may be removed from the 3D model device.

The unwinder panel selection button 470 is a button manipulated to display an unwinder operation panel on the screen of the facility operator 120, and the rewinder panel selection button 480 is a button manipulated to display a rewinder operation on the screen of the facility operator 120. **In** accordance with the button manipulation of the user, the facility operator 120 may display the unwinder operation panel including a plurality of set value input windows and a plurality of manipulation buttons for executing, changing and/or correcting the operation of the unwinder part of the 3D slitter, or may display the rewinder operation panel including a plurality of set value input windows and a plurality of manipulation buttons for executing, changing and/or correcting the operation of the rewinder part of the 3D slitter.

The quality measurement tool 490 displays various tool icons for measuring the quality of the material produced by the 3D model device. When the 3D model device is a slitter, the tool icon may include a steel ruler or the like.

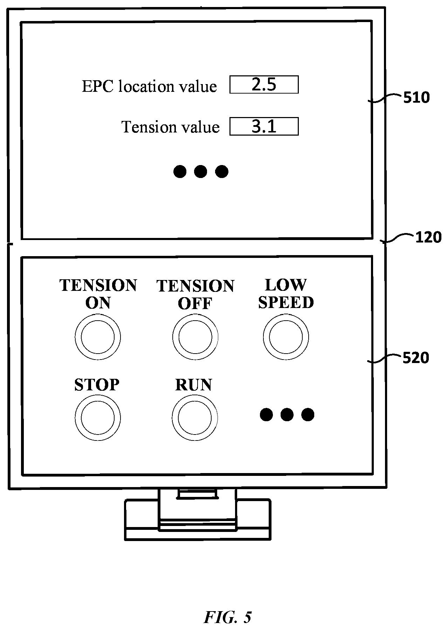

FIG. 5 is a diagram illustrating an example of a display screen displayed or output to a facility operator associated with a 3D slitter according to an example embodiment. According to an example embodiment, the slitter may refer to a device for cutting a coated part or uncoated part of an electrode to a desired width by passing a rolled electrode between two rotating upper and lower knives. A slitter may include multiple lanes. In the slitting process performed by such a slitter, the slitting width specified in the specification of the work order must be kept constant and cut to produce a good quality material, and to this end, the unwinder should function to unwind the electrode at a constant speed. In addition, after slitting, rewinding should be performed with a constant tension for each reel. The user may determine or adjust various adjustment parameters to maintain a constant slitting width. To this end, the facility operator 120 may include an area 510 including a plurality of set value input windows for inputting text such as material information recorded in the work order and its specification information (e.g., EPC location value, tension value) and an area 520 including a plurality of manipulation buttons to be touched while working on the slitter. The facility operator 120 may be additionally displayed by overlapping a plurality of screens having separate layouts while the simulation device of the present disclosure is operated. Button names may be displayed on each of the plurality of manipulation buttons, and when the user touches an arbitrary manipulation button area, the color, shape or image of the corresponding manipulation button may be changed during the touch to recognize that the state of the manipulation button is being changed. In addition, when the user touches an arbitrary manipulation button area for a predetermined time or longer, the color, shape, or image of the corresponding manipulation button may be changed to recognize that the state of the corresponding manipulation button has been changed. In addition, when one button is touched, a button linked to the corresponding button may be activated. For example, when the TENSION ON button and the TENTION OFF button are interlocked, the STOP button and the RUN button are interlocked, and when one interlocked button is touched and driven, the other interlocked button may be activated and may be changed to a touchable state.

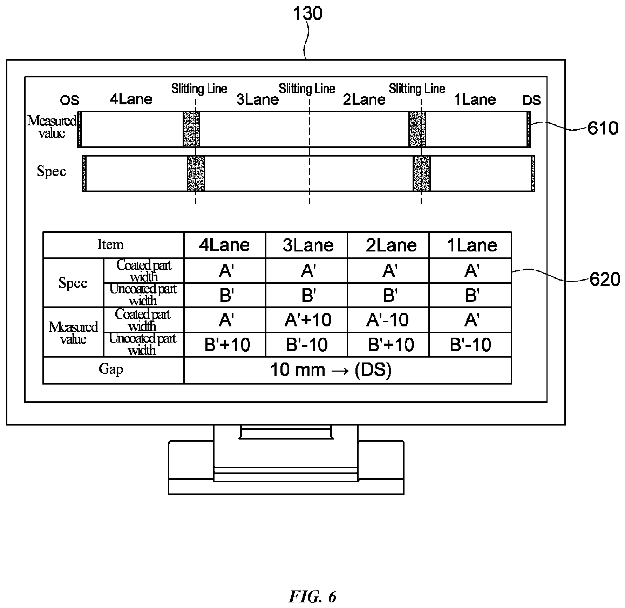

FIG. 6 is a diagram illustrating an example of an edge position control (EPC) adjustment training operation according to an example embodiment. The simulation device (100 in FIG. 1) may determine one condition adjustment training scenario among the operation preparation training scenarios of the 3D slitter, and may change at least one of the operation of the 3D slitter and the quality information associated with the quality of the material based on the determined one or more condition adjustment training scenarios. Here, the plurality of condition adjustment training scenarios may include an EPC adjustment training operation. For example, the EPC adjustment training operation may refer to a situation in which the coated part width and the uncoated part width, i.e., the slitting width, of the material (rewound roll for each lane) is different from the specifications set in the work order.

According to an example embodiment, when the EPC adjustment training is executed, the simulation device may change the coated part width and the uncoated part width of the rewound roll wound on each lane generated in the 3D slitter to predetermined values. Here, the location of the rewound roll wound on each lane of the 3D slitter included in the device operator 130 may be maintained in a fixed state, or, optionally, the location of the rewound roll wound on each lane may be changed to a predetermined area (e.g., images, videos, animations, etc., of dots, lines, planes, etc., representing rewound rolls). When the slitting width defect occurs in this way, an alarm may be generated.

When this EPC adjustment training situation occurs, the user may perform EPC adjustment training by manipulating the manipulation button displayed on the facility operator 120, changing the adjustment parameter displayed on the facility operator 120, or touching or dragging a specific area of the 3D slitter displayed on the device operator 130. In other words, the simulation device receives button manipulation information for touching at least one manipulation button from the user to stop the driving of the 3D slitter and release the tension, receives user behavior information touching a specific area (work order selection button) of the device operator from the user to output the work order, receives user behavior information touching a specific area (quality check tool) of the device operator from the user to output a still ruler image, and receive user behavior information of dragging the still ruler image onto the rewound roll image wound on each lane from the user to output the coated part width and uncoated part width values for each lane. In addition, when the measurement of the coated part width and the uncoated part width of each lane for all lanes is completed (when user behavior information touching the NEXT button is received from the user), as shown in FIG. 6, the specification values and measured values for the coated part width and the uncoated part width of all lanes are output as a graph 610 and a table 620, and a measure method for solving the slitting width error is also output (e.g., 10 mm movement of the jumbo roll in the installation direction (DS direction)).

Thereafter, when user condition information for changing the sett value of the adjustment parameter corresponding to the EPC location value is received from the facility operator, an animation in which the EPC-related partial area of the device operator moves in the direction of the facility may be output, and the quality information of the material changed to defective may be corrected normally. The simulation device may determine whether the EPC adjustment training has been completed based on at least some areas of the corrected material. For example, when user behavior information, button manipulation information, and user condition information are input in a predetermined area or value in a predetermined order, the simulation device may determine that the EPC adjustment training is completed. When it is determined that the EPC adjustment training is completed, the predetermined area indicating the slitting width defect may be removed on the image, video and/or animation of the 3D slitter, and the slitting width measurement value output through the action of measuring the coated part width and the uncoated part width for each lane may be output to match the specification value.

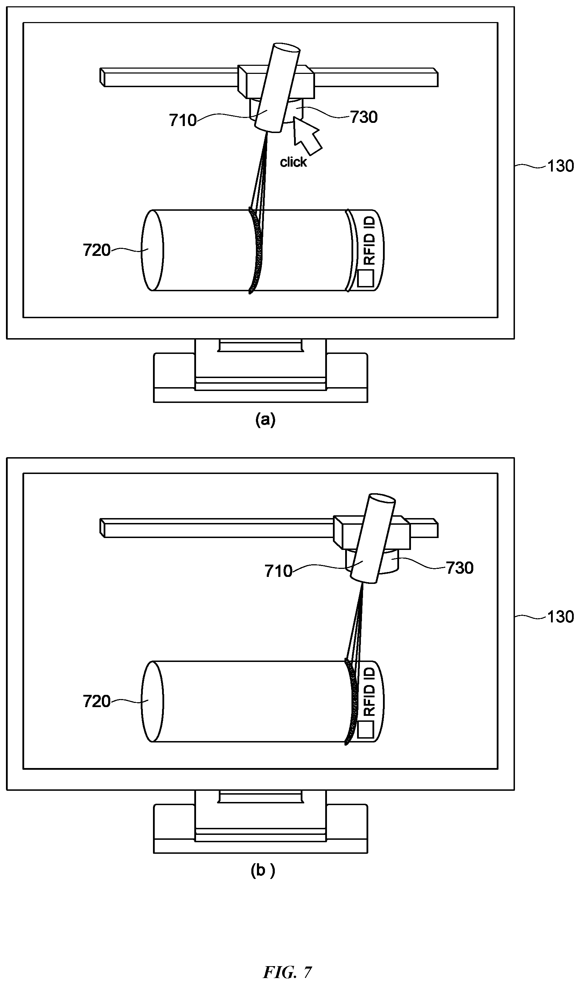

FIG. 7 is a diagram illustrating an example of an optical sensor location adjustment training operation according to an example embodiment. The simulation device (100 in FIG. 1) may determine one condition adjustment training scenario among the operation preparation training scenarios of the 3D slitter, and may change at least one of the operation of the 3D slitter and the quality information associated with the quality of the material based on the determined one or more condition adjustment training scenarios. Here, the plurality of condition adjustment training scenarios may include an optical sensor location adjustment training operation. For example, the optical sensor location adjustment training operation may refer to a situation in which an abnormality occurs in the transverse winding of the rewound roll. The optical sensor is for determining the location of the end of the electrode wound on the rewound roll, and when the location of the optical sensor is abnormal, abnormality in the transverse winding of the rewound roll may occur.

According to an example embodiment, when the optical sensor location adjustment training is executed, as shown in A of FIG. 7, the simulation device may change the irradiation location of the optical sensor 710 to a predetermined abnormal location (e.g., inside the core of the rewound roll 720 for each lane, not a groove). When the optical sensor location is changed to an abnormal location in this way, an alarm may occur, and the user may perform training to correct the optical sensor location to a normal location (a groove formed in the core of the rewound roll 720 for each lane).

When such an optical sensor location adjustment training situation occurs, the user may operate the manipulation button displayed on the facility operator 120, or change the adjustment parameter displayed on the facility operator 120 or touch or drag a specific area of the 3D slitter displayed on the device operator 130 to perform optical sensor location adjustment training. In other words, the simulation device may receive button manipulation information for touching at least one manipulation button from the user to stop the driving of the 3D slitter, receive user behavior information for touching or dragging a specific area of the device operator (e.g., area of the optical sensor fixing screw 730) in one rotation direction from the user to output an image for unlocking the optical sensor fixing screw, receive user behavior information for touching or dragging a specific area (area of the optical sensor 710) of the device operator from the user to move the image of the optical sensor 710 and output it, and receive user behavior information for touching or dragging a specific area (e.g., area of the optical sensor fixing screw 730) of the device operator in another rotation direction from the user to output an image of locking the optical sensor fixing screw. Through this series of processes, the irradiation location of the optical sensor 710 may be corrected to a predetermined normal location (e.g., the end of the rewound roll 720 for each lane) as shown in FIG. 7B.

The simulation device may repeatedly perform optical sensor location adjustment training for all lanes, and after completing optical sensor location adjustment training for one lane, may automatically correct the optical sensor locations of the remaining three lanes from an abnormal location (non-groove location formed in the rewound roll core of each lane) to a normal location (location of the groove formed at the end of each lane, i.e., the rewound roll core for each lane).

In this way, the simulation device may determine whether the optical sensor location adjustment training is completed based on the state of the 3D model device. For example, when user behavior information, button manipulation information, and user condition information are input to a predetermined area or value in a predetermined order, the simulation device may determine that the optical sensor location adjustment training is completed. When it is determined that the optical sensor location adjustment training is completed, the location of the optical sensor is moved from the predetermined abnormal location to the predetermined normal location, which may be implemented as an image, video and/or animation of a 3D slitter.

In FIG. 7, an image, video, and/or animation representing a part of the 3D slitter is displayed on the device operator 130, but is not limited thereto, and the device operator 130 may include an image, video, and/or animation having the same shape as the real slitter. With such a configuration, the user may effectively train in advance how to respond to issues that may occur in the slitting process, and the simulation device may effectively determine whether the corresponding training is completed based on the operation of the user input or received.

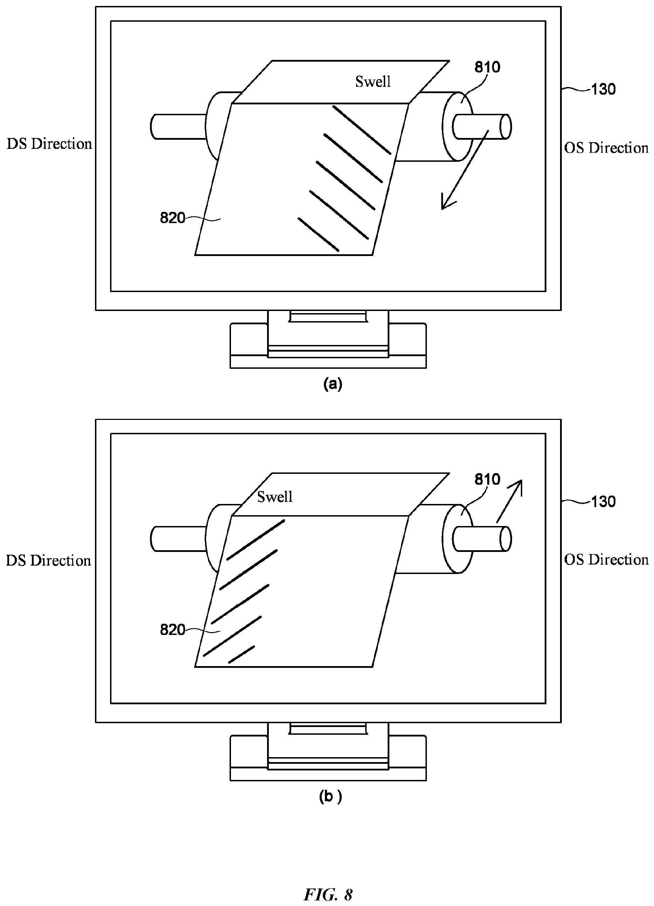

FIG. 8 is a diagram illustrating an example of a leveling roll adjustment training operation according to an example embodiment. The simulation device (100 in FIG. 1) may determine one condition adjustment training scenario among the operation preparation training scenarios of the 3D slitter, and may change at least one of the operation of the 3D slitter and the quality information associated with the quality of the material based on the determined one or more condition adjustment training scenarios. Here, the plurality of condition adjustment training scenarios may include a leveling roll adjustment training operation. For example, the leveling roll adjustment training operation may refer to a situation in which a swell occurs on the surface of the electrode fabric that has passed through the leveling roll of the unwinder part. As shown in A and B of FIG. 8, depending on the location of the leveling roll 810, the swell may occur in the equipment direction (DS direction) or the worker direction (OS direction) of the surface of the electrode fabric 820.

According to an example embodiment, when the leveling roll adjustment training is executed, as shown in A and B of FIG. 8, the simulation device may change the location to a predetermined abnormal location by moving the worker direction (OS direction) axis of the leveling adjustment roll 810 forward or backward. When the location of the leveling roll 810 is changed in this way, a swell occurs on the surface of the material (electrode fabric 820 passed through the leveling roll) produced in the slitter in one of the equipment direction (DS direction) and the worker direction (OS direction). When the leveling adjustment roll location is changed to the abnormal location in this way, an alarm may occur, and the user may perform training to correct the leveling adjustment roll location to the normal location.

When such a leveling roll adjustment training situation occurs, the user may perform leveling roll adjustment training by manipulating the manipulation button displayed on the facility operator 120, changing the adjustment parameter displayed on the facility operator 120, or touching or dragging a specific area of the 3D slitter displayed on the device operator 130. In other words, the simulation device receives button manipulation information for touching at least one manipulation button from the user to give tension and operate the equipment at a low speed, and may receive user behavior information for touching a specific region (e.g., unwinder part) of the device operator from the user to output an animation in which a swell occurs on the surface of the electrode fabric that has passed through the leveling roll. In addition, the simulation device may receive user behavior information for touching or dragging a specific area (e.g., leveling roll adjustment lever) of the device operator from the user and output an animation for moving the location of the leveling roll forward or backward, and as the location of the leveling roll is changed in this way, the simulation device may correct the quality of the material (the surface of the electrode fabric that has passed through the leveling roll) (swell removing).

In this way, the simulation device may determine whether the leveling roll adjustment training is completed based on the state of the 3D model device. For example, when user behavior information, button manipulation information, and user condition information are input in a predetermined area or value in a predetermined order, the simulation device may determine that the leveling roll adjustment training is completed. When it is determined that the leveling roll adjustment training is completed, the axial location in the worker direction of the leveling roll moves from the predetermined abnormal location to the predetermined normal location, which may be implemented with images, videos and/or animations of the 3D slitter. Through this leveling roll adjustment training, the user may learn about the adjustment direction and adjustment method of the leveling roll axis according to whether and where the swell occurs on the surface of the fabric.

In FIG. 8, an image, video, and/or animation representing a part of the 3D slitter is displayed on the device operator 130, but the present disclosure is not limited thereto, and the device operator 130 may include an image, video, and/or animation having the same shape as the real slitter. With such a configuration, the user may effectively train in advance how to respond to issues that may occur in the slitting process, and the simulation device may effectively determine whether the training is completed based on the operation of the user input or received.

In FIGS. 6 to 8, EPC adjustment training, optical sensor location adjustment training, leveling roll adjustment training, etc., have been described above as existing, but a plurality of operation preparation training scenarios may further include other training that may occur in the slitter.

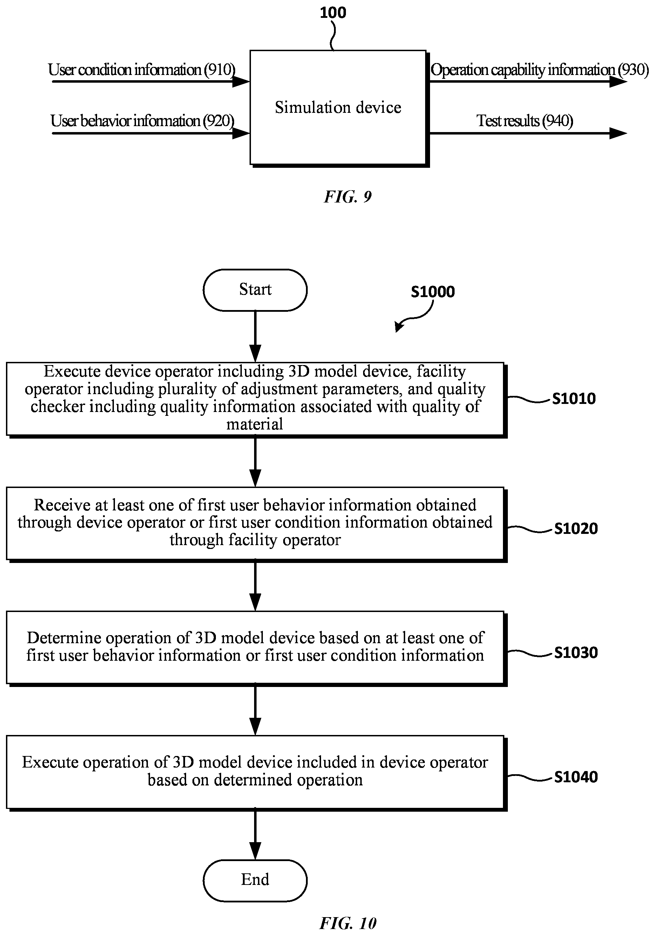

FIG. 9 is a diagram illustrating an example in which operation capability information 930 and test results 940 are generated according to an example embodiment. As described above, when a training scenario occurs, the simulation device 100 may receive user condition information 910, user behavior information 920, and the like from the user, and may determine whether the training scenario is completed based on the received user condition information 910, user behavior information 920, and the like.

According to an example embodiment, when it is determined that the training scenario is completed, the simulation device 100 may calculate a running time and a loss value while the training scenario is in progress, and may generate operation capability information 930 for the 3D model device of the user account based on the calculated running time and loss value. In this case, the test result 940 may be output together with the operation capability information 930. For example, a user associated with the corresponding user account may perform a test for any training scenario, and when all training scenarios associated with a specific 3D model device are solved according to a predetermined criterion, the simulation device 100 may determine that the corresponding user has passed a simulation test for the specific 3D model device.

FIG. 10 is a diagram illustrating an example of a simulation method (S1000) for secondary battery production according to an example embodiment. The simulation method S1000 for secondary battery production may be performed by a processor (e.g., at least one processor of the simulation device). As shown, the simulation method S1000 for secondary battery production may be started when the processor outputs a device operator including a 3D model device associated with secondary battery production, a facility operator including a plurality of adjustment parameters for determining the operation of the 3D model device, and a quality checker including quality information associated with the quality of the material generated by the 3D model device (S1010).

The processor may obtain at least one of the first user behavior information obtained through the device operator and the first user condition information obtained through the facility operator (S 1020). Here, the first user condition information may include information associated with a value corresponding to at least one adjustment parameter among the plurality of adjustment parameters.

The processor may determine the operation of the 3D model device based on at least one of the obtained first user behavior information and the first user condition information (S 1030). Further, the processor may execute an operation of the 3D model device included in the device operator based on the determined operation (S 1040). When receiving the first user behavior information, the processor may determine whether the received first user behavior information corresponds to a predetermined operating condition of the 3D model device, and when it is determined that the first user behavior information corresponds to a predetermined operating condition of the 3D model device, may permit the operation of the 3D model device.

According to an example embodiment, the processor may determine one or more quality parameters for determining the quality of the material generated by the 3D model device, and while the operation of the 3D model device is being executed, may calculate a value corresponding to each of the one or more quality parameters determined based on the operation of the 3D model device being executed. In addition, the processor may generate quality information associated with the quality of the material generated by the 3D model device based on a value corresponding to each of the calculated one or more quality parameters.

According to an example embodiment, the processor may determine one or more defect scenarios among a plurality of defect scenarios associated with a malfunction of the 3D model device, and may change at least one of the quality information associated with the quality of the material and the operation of the 3D model device based on the determined one or more defect scenarios. Then, the processor may receive at least one of second user behavior information and second user condition information for resolving the determined one or more defect scenarios, and may correct the changed operation of the 3D model device based on at least one of the received second user behavior information and the second user condition information. Further, the processor may calculate a value corresponding to each of a plurality of quality parameters associated with the quality of a material generated by the 3D model device based on the operation of the 3D model device being executed while the operation of the corrected 3D model device is executed. In this case, the processor may correct the quality information associated with the quality of the material generated by the corrected 3D model device based on the values corresponding to each of the calculated plurality of quality parameters, and may use the corrected quality information to determine whether one or more defect scenarios are resolved.

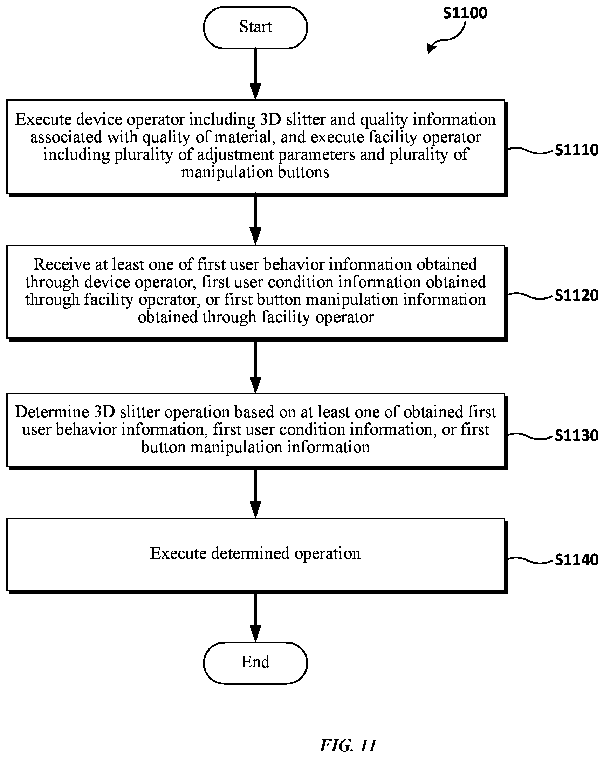

FIG. 11 is a diagram illustrating an example of a simulation method (S1100) of a slitter for secondary battery production according to an example embodiment. The simulation method S1100 of the slitter for secondary battery production may be performed by a processor (e.g., at least one processor of the simulation device). As shown, the simulation method (S1100) of the slitter for secondary battery production may be initiated by the processor executing the device operator including the 3D slitter associated with the production of the secondary battery and the quality information associated with the quality of the material generated by the 3D slitter, and executing the facility operator including a plurality of adjustment parameters for determining an operation of the 3D slitter and a plurality of manipulation buttons for operating the 3D slitter (S1110).

The processor may obtain at least one of the first user behavior information obtained through the device operator, the first button manipulation information obtained through the facility operator, and the first user condition information obtained through the facility operator (S1120). In addition, the processor may determine a 3D slitter operation of at least one of jumbo roll input, jumbo roll replacement, rewound roll cutting, lot end, rewound roll takeout, rewound roll core input, and lot start based on at least one of the obtained first user behavior information, the first button manipulation information, and the first user condition information (S1130). In addition, the processor may execute an operation associated with the 3D slitter based on the determined operation (S1140).

According to an example embodiment, the processor may change the adjustment parameter displayed on the facility operator based on the first user behavior information. In addition, when receiving the button manipulation information, when it is determined that the received button manipulation information corresponds to a predetermined button manipulation, the processor may permit the operation of the 3D slitter.

According to an example embodiment, the processor may drive the 3D slitter by animation based on the 3D slitter training scenario, change the quality information associated with the quality of the material generated in the 3D slitter, output a user behavior guide for inducing user behavior on the device operator, or output a button manipulation guide for inducing button manipulation on the facility operator or a user condition guide for inducing a user condition input on the facility operator.

According to an example embodiment, the processor may determine one or more training scenarios among a plurality of training scenarios associated with condition adjustment among the operation preparation training scenarios of the 3D slitter, and may change at least one of the quality information associated with the quality of the material and the operation of the 3D slitter based on the determined one or more training scenarios. For example, the plurality of training scenarios may include EPC adjustment training, optical sensor location adjustment training, leveling roll adjustment training, and the like. In this case, each training scenario may be completed by arbitrary user condition information, button manipulation information, and user behavior information input from the user.

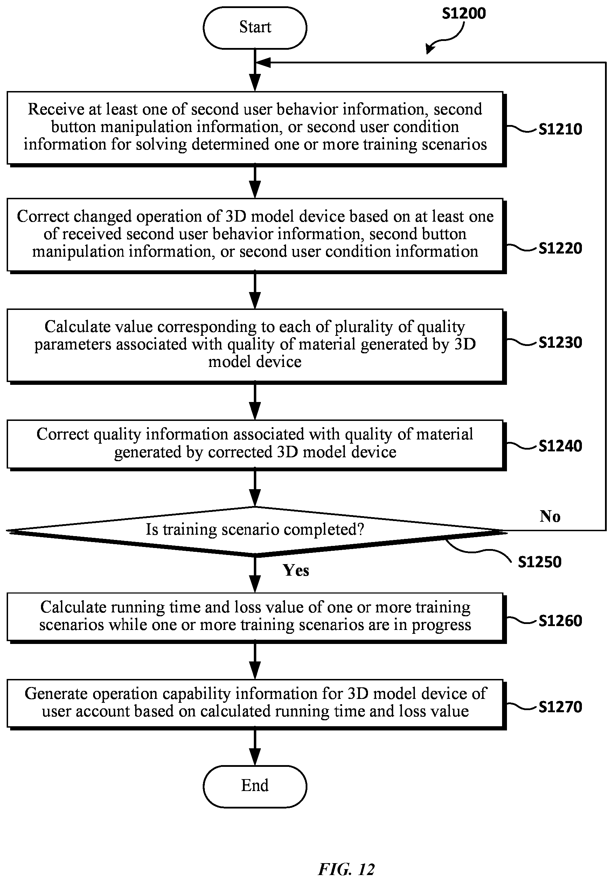

FIG. 12 is a diagram illustrating an example of a test result calculation method (S1200) according to an example embodiment. The test result calculation method (S 1200) may be performed by a processor (e.g., at least one processor of the simulation device). As shown, the test result calculation method (S 1200) may be initiated by the processor receiving at least one of second user behavior information, second button manipulation information, and second user condition information for solving the determined one or more training scenarios (S1210).

As described above, the processor may correct the changed operation of the 3D model device based on at least one of the received second user behavior information, the second button manipulation information, and the second user condition information (S 1220). Further, the processor may calculate a value corresponding to each of a plurality of quality parameters associated with the quality of a material generated by the 3D model device based on the operation of the 3D model device being executed, while the operation of the corrected 3D model device is executed (S1230). In this case, the processor may correct the quality information associated with the quality of the material generated by the corrected 3D model device based on the values corresponding to each of the plurality of calculated quality parameters (S 1240).

Then, the processor may determine whether one or more training scenarios are completed using the corrected quality information and/or set values and condition values of the 3D model device and the like (S1250). When it is determined that the training scenario is not completed, the processor may generate or obtain second user behavior information, second button manipulation information, second user condition information, etc., again using the information input by the user.

When it is determined that one or more training scenarios have are completed, the processor may calculate a running time and loss value of one or more training scenarios while the one or more training scenarios are in progress (S 1260). In addition, the processor may generate operation capability information for the 3D model device of the user account based on the calculated running time and loss value (S 1270). Here, the operation capability information may include, but is not limited to, the running speed and accuracy calculated using the running time, the loss value, and the like, and may further include the user's test score, whether the test has passed, and the like. In this case, one user account may be assigned to each user performing secondary battery production, and operation capability information generated based on the user's training scenario running time, loss value, etc., may be stored or managed in association with the user account.

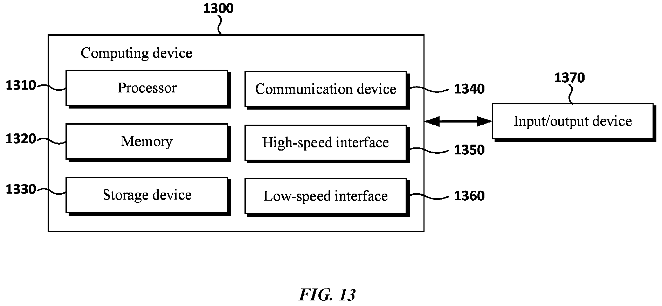

FIG. 13 is a diagram illustrating an exemplary computing device 1300 for performing the above-described method and/or example embodiment, and the like. According to an example embodiment, the computing device 1300 may be implemented using hardware and/or software configured to interact with a user. Here, the computing device 1300 may include the above-described simulation device (100 in FIG. 1). For example, the computing device 1300 may be configured to support a virtual reality (VR), augmented reality (AR), or mixed reality (MR) environment, but is not limited thereto. The computing device 1300 may include a laptop, a desktop, a workstation, a personal digital assistant, a server, a blade server, a main frame, etc., but is not limited thereto. The components of computing device 1300 described above, their connection relationships, and their functions are intended to be illustrative, and not intended to limit the implementations of the disclosure described and/or claimed herein.

The computing device 1300 includes a processor 1310, a memory 1320, a storage device 1330, a communication device 1340, a high-speed interface 1350 connected to the memory 1320 and high-speed expansion port, and a low-speed interface 1360 connected to the low-speed bus and storage device. Each of the components 1310, 1320, 1330, 1340, and 1350 may be interconnected using a variety of buses, mounted on the same main board, or mounted and connected in another suitable manner. The processor 1310 may be configured to process instructions of a computer program by performing basic arithmetic, logic, and input/output operations. For example, the processor 1310 may process instructions stored in the memory 1320, storage device 1330, etc., and/or instructions executed within the computing device 1300 to display graphic information on an external input/output device 1370, such as a display device connected to the high-speed interface 1350.

The communication device 1340 may provide a configuration or function for the input/output device 1370 and the computing device 1300 to communicate with each other through a network, and may provide a configuration or function for supporting the input/output device 1370 and/or the computing device 1300 to communicate with other external devices, etc. For example, a request or data generated by a processor of an external apparatus according to an arbitrary program code may be transmitted to the computing device 1300 through a network under the control of the communication device 1340. Conversely, a control signal or instruction provided under the control of the processor 1310 of the computing device 1300 may be transmitted to another external apparatus through the communication device 1340 and a network.

In FIG. 13, the computing device 1300 is illustrated as including one processor 1310, one memory 1320, and the like, but is not limited thereto, and the computing device 1300 may be implemented using a plurality of memories, a plurality of processors, and/or a plurality of buses, etc. In addition, although it has been described above that one computing device 1300 exists in FIG. 13, the present disclosure is not limited thereto, and a plurality of computing devices may interact and perform an operation necessary to execute the above-described method.

The memory 1320 may store information in the computing device 1300. According to an example embodiment, the memory 1320 may include a volatile memory unit or a plurality of memory units. Additionally or alternatively, the memory 1320 may include a non-volatile memory unit or a plurality of memory units. In addition, the memory 1320 may include another type of computer-readable medium, such as a magnetic disk or an optical disk. In addition, an operating system and at least one program code and/or instruction may be stored in the memory 1320.

The storage device 1330 may be one or more mass storage devices for storing data for computing device 1300. For example, the storage device 1330 may be a non-transitory computer-readable medium including magnetic discs such as hard disks, removable disks, optical discs, semiconductor memory devices such as erasable programmable read-only memory (EPROM), electrically erasable PROM (EEPROM), flash memory devices, CD-ROM and DVD-ROM, or may be configured to include such a non-transitory computer-readable medium. In addition, the computer program may be tangibly embodied in such a non-transitory computer-readable medium.

The high-speed interface 1350 and the low-speed interface 1360 may be means for interaction with the input/output device 1370. For example, input devices may include devices such as cameras, keyboards, microphones, mice, etc., including audio sensors and/or image sensors, and output devices may include devices such as displays, speakers, haptic feedback devices, and the like. In another example, the high-speed interface 1350 and the low-speed interface 1360 may be means for interfacing with a device in which a configuration or function for performing input and output, such as a touch screen, is integrated into one.

According to an example embodiment, while the high-speed interface 1350 manages bandwidth-intensive operations for computing device 1300, the low-speed interface 1360 may manage lower bandwidth intensive operations than the high-speed interface 1350, but such function assignment is merely exemplary. According to an example embodiment, the high-speed interface 1350 may be coupled to the memory 1320, the input/output device 1370, and high-speed expansion ports capable of accommodating various expansion cards (not shown). In addition, the low-speed interface 1360 may be coupled to the storage device 1330 and the low-speed expansion port. Additionally, the low-speed expansion port that may include various communication ports (e.g., USB, Bluetooth, Ethernet, Wireless Ethernet) may be coupled to one or more input/output devices 1370 such as a keyboard, a pointing device, a scanner, or a networking device such as a router, a switch, etc., through a network adapter or the like.

The computing device 1300 may be implemented in a number of different forms. For example, the computing device 1300 may be implemented as a standard server, or a group of such standard servers. Additionally or alternatively, the computing device 1300 may be implemented as part of a rack server system, or implemented as a personal computer, such as a laptop computer. In this case, components from the computing device 1300 may be coupled to other components in any mobile device (not shown). Such computing device 1300 may include, or be configured to communicate with, one or more other computing devices.

In FIG. 13, the input/output device 1370 is not included in the computing device 1300, but is not limited thereto, and may be configured as a single device with the computing device 1300. In addition, in FIG. 13, the high-speed interface 1350 and/or the low-speed interface 1360 is illustrated as an element configured separately from the processor 1310, but is not limited thereto, and the high-speed interface 1350 and/or the low-speed interface 1360 may be configured to be included in the processor.

The methods and/or various example embodiments as described above may be implemented in digital electronic circuitry, computer hardware, firmware, software, and/or combinations thereof. Example embodiments of the present disclosure may be implemented as a non-transitory computer-readable medium and/or a computer program stored in a non-transitory computer-readable medium or executed by a data processing apparatus, e.g., one or more programmable processors and/or one or more computing device. The computer program as described above may be written in any form of a programming language, including compiled or interpreted languages, and may be deployed in any form, including as a stand-alone program, a module, a subroutine, or the like. A computer program may be deployed through one computing device, multiple computing devices connected by the same network and/or multiple computing devicees connected by a plurality of different networks.

The methods and/or various example embodiments as described above may be performed by one or more processors configured to execute one or more computer programs that process, store, and/or manage any operations, functions, etc., by operating or generating output data based on input data. For example, the methods and/or various example embodiments of the present disclosure may be performed by a special purpose logic circuit such as a field programmable gate array (FPGA) or application specific integrated circuit (ASIC), and the device and/or system for performing the methods and example embodiments of the present disclosure may be implemented as special purpose logic circuits such as FPGAs or ASICs.

One or more processors for processing a computer program may include both general or special purpose microprocessors, and/or any one or more processors of any kind of digital computing device. A processor may receive instructions and/or data from a read-only memory or a random-access memory, or both. Components of a computing device for executing the methods and/or example embodiments of the present disclosure may include at least one processor for executing instructions and one or more memory devices for storing instructions and/or data.

According to an example embodiment, a computing device may receive from and transmit data to one or more mass storage devices for storing data. For example, the computing device may receive data from and/or transmit data to magnetic disks or optical disks. A non-transitory computer-readable medium suitable for storing instructions and/or data associated with a computer program may include any type of non-volatile memory including semiconductor memory devices such as erasable programmable read-only memory (EPROM), electrically erasable PROM (EEPROM), and flash memory devices, but is not limited thereto. For example, the non-transitory computer readable medium may include a magnetic disk such as an internal hard disk or a removable disk, a photomagnetic disk, a CD-ROM and a DVD-ROM disk.

To provide interaction with a user, the computing device may include a display device (e.g., a cathode ray tube (CRT), a liquid crystal display (LCD), etc.) for presenting or displaying information to the user, and a pointing device (e.g., a keyboard, mouse, trackball, etc.) through which the user may provide input and/or commands, or the like, on the computing device, but is not limited thereto. In other words, the computing device may further include any other kind of device for providing interaction with the user. For example, the computing device may provide any form of sensory feedback to the user for interaction with the user, including visual feedback, auditory feedback, and/or tactile feedback, and the like. In contrast, the user may provide an input to the computing device through various gestures such as sight, voice, and motion.

In the present disclosure, various example embodiments may be implemented in a computing device including a back-end component (e.g., a data server), a middleware component (e.g., an application server) and/or a front-end component. In this case, the components may be interconnected by any form or medium of digital data communication, such as a communication network. According to an example embodiment, the communication network may include wired networks such as Ethernet, Power Line Communication, telephone line communication apparatus, and RS-serial communication, mobile communication networks, wireless networks such as WLAN (Wireless LAN), Wi-Fi, Bluetooth, and ZigBee, or a combination thereof. For example, the communication network may include a local area network (LAN), a wide area network (WAN), and the like.

A computing device based on the exemplary embodiments described herein may be implemented using hardware and/or software configured to interact with the user, including a user device, a user interface (UI) device, a user terminal, or a client device. For example, the computing device may include a portable computing device such as a laptop computer. Additionally or alternatively, the computing device may include personal digital assistants (PDA), tablet PCs, game consoles, wearable devices, internet of things (IoT) devices, virtual reality (VR) devices, augmented reality (AR) devices, but is not limited thereto. The computing device may further include other types of devices configured to interact with the user. In addition, the computing device may include a portable communication device suitable for wireless communication over a network such as a mobile communication network (e.g., a mobile phone, a smart phone, a wireless cellular phone, etc.), and the like. The computing device may be configured to communicate with a network server wirelessly using wireless communication technologies and/or protocols such as radio frequency (RF), microwave frequency (MWF), and/or infrared ray frequency (IRF).

In the present disclosure, various example embodiments including specific structural and functional details are illustrative. Therefore, example embodiments of the present disclosure are not limited to those described above, and may be implemented in various other forms. In addition, the terms used herein are intended merely to describe some example embodiments and are not to be construed as limiting the example embodiments. For example, singular words and the above may be construed to include the plurals as well, unless the context clearly dictates otherwise.

Unless otherwise defined herein, all terms used herein including technical or scientific terms have the same meanings as those generally understood by a person skilled in the art. In addition, commonly used terms such as terms defined in the dictionary should be interpreted as having a meaning consistent with the meaning in the context of the related art.

The protection scope of the appended claims is to interpreted according to Art. 69 of the EPC protocol.

## Claims

1. A slitter simulation apparatus for secondary battery production, comprising:
a) a memory (1320) configured to store at least one instruction; and
b) at least one processor (1310) configured to execute the at least one instruction stored in the memory (1320) to perform operations (310, 320, 330, 340, 350, 360) comprising:
c1) executing (S1010, S1110) a software module device operator (130, 210) comprising a 3D slitter associated with secondary battery production and quality information related to quality of a material generated by the 3D slitter, wherein the 3D slitter is a virtual 3D slitter;
c2) executing (S1010, S1110) a software module facility operator (120) comprising a plurality of adjustment parameters for determining an operation (310, 320, 330, 340, 350, 360) of the 3D slitter and a plurality of operation buttons for driving the 3D slitter;
c3) obtaining (S1020, S1120) at least one of first user behavior information obtained through a device operator input/output device, first button manipulation information obtained through a facility operator input/output device, or first user condition information obtained through the facility operator input/output device;
c4) determining (S1030, S1130) the operation (310, 320, 330, 340, 350, 360) of the 3D slitter based on at least one of the first user behavior information, the first button manipulation information, or the first user condition information;
c5) executing (S1040, S1140) the operation (310, 320, 330, 340, 350, 360) of the 3D slitter; and
c6) executing a 3D slitter training scenario including an operation preparation training scenario based on an operation process of the 3D slitter;
c7) wherein the 3D slitter performs the operation preparation training scenario where at least some of a set value, a condition value, and the quality information corresponding thereto of the 3D slitter is changed to an abnormal range.

2. The slitter simulation apparatus for secondary battery production according to claim 1, wherein the operations further comprise:
displaying an unwinder operation panel for determining an operation of an unwinder part of the 3D slitter on the facility operator input/output device; and
displaying a rewinder operation panel for determining an operation (330, 340, 350, 360) of a rewinder part of the 3D slitter on the facility operator input/output device.

3. The slitter simulation apparatus for secondary battery production according to claim 1, wherein the operations further comprise:
executing at least one of user behavior guide display on the device operator input/output device, user condition guide display on the facility operator input/output device, or button manipulation guide display on the facility operator input/output device according to the 3D slitter training scenario;
obtaining at least one of the first user behavior information based on the user behavior guide display, the first button manipulation information based on the button manipulation guide display, or the first user condition information based on the user condition guide display; and
changing at least one of the software module device operator (130, 210) or the software module facility operator (120) based on at least one of the first user behavior information based on the user behavior guide display, the first button manipulation information based on the button manipulation guide display, or the first user condition information based on the user condition guide display.

4. The slitter simulation apparatus for secondary battery production according to claim 3, wherein the 3D slitter training scenario further comprises an operation training scenario or a quality check training scenario.

5. The slitter simulation apparatus for secondary battery production according to claim 4, wherein the operation training scenario comprises at least one of a jumbo roll loading training operation, a jumbo roll replacement training operation (340), a rewound roll (720) cutting training operation (340), a lot end training operation, a rewound roll (720) taking out training operation (340), a rewound roll (720) core loading training operation (340), or a lot starting training operation (340).

6. The slitter simulation apparatus for secondary battery production according to claim 4, wherein the quality check training scenario comprises at least one of a width measurement training operation (350), a mismatch measurement training operation (350), a defective tag quantity checking operation (350), a folding level checking operation (350), or a swell level checking operation (350).

7. The slitter simulation apparatus for secondary battery production according to claim 1, wherein the operation preparation training scenario comprises at least one of an inspection training operation (330), a tension adjustment training operation (330), an EPC adjustment training operation (330), an optical sensor (710) location adjustment training operation (330), a leveling roll (810) adjustment training operation (330), or an auto labeler adjustment training operation (330).

8. The slitter simulation apparatus for secondary battery production according to claim 7, wherein the operations further comprise:
determining a training operation (330, 340, 350) of the operation preparation training scenarios of the 3D slitter; and
changing at least one of the operation (330, 340, 350) of the 3D slitter or the quality information related to the quality of the material to a first range based on the determined training operation.

9. The slitter simulation apparatus for secondary battery production according to claim 8, wherein, when the determined training scenario is the EPC adjustment training operation (330),
the operations (330) further include changing a coated part width and an uncoated part width of a rewound roll wound on a lane of the 3D slitter to be different from predetermined specification values.

10. The slitter simulation apparatus for secondary battery production according to claim 8, wherein, when the determined training scenario is the optical sensor location adjustment training operation (330),
the operations (330) further comprise changing an irradiation location of an optical sensor (710) to a location other than a home location formed in a rewound roll core wound on a lane of the 3D slitter.

11. The slitter simulation apparatus for secondary battery production according to claim 8, wherein, when the determined training scenario is the leveling roll adjustment training operation (330),
the operations (330) further comprise outputting a swell on a surface of an electrode fabric (820) which has passed through a leveling roll (810).

12. The slitter simulation apparatus for secondary battery production according to claim 8, wherein the operations further comprise:
obtaining (S1210) at least one of second user behavior information obtained through the device operator input/output device, second button manipulation information obtained through the facility operator input/output device, or second user condition information obtained through the facility operator input/output device; and
changing (S1220, S1240) at least one of the operation (360) of the 3D slitter or the quality information related to the quality of the material changed to the first range to a second range based on at least one of the second user behavior information, the second button manipulation information, or the second user condition information.

13. A slitter simulation method for secondary battery production performed by at least one processor (1310), comprising:
a) executing (S1010, S1110) a software module device operator (130, 210) comprising a 3D slitter associated with secondary battery production and quality information related to quality of a material generated by the 3D slitter, wherein the 3D slitter is a virtual 3D slitter;
b) executing (S1010, S1110) a software module facility operator (120) comprising a plurality of adjustment parameters for determining an operation (310, 320, 330, 340, 350, 360) of the 3D slitter and a plurality of operation buttons for driving the 3D slitter;
c) obtaining (S1020, S1120) at least one of first user behavior information obtained through a device operator input/output device, first button manipulation information obtained through a facility operator input/output device, or first user condition information obtained through the facility operator input/output device;
d) determining (S1030, S1130) the operation (310, 320, 330, 340, 350, 360) of the 3D slitter based on at least one of the first user behavior information, the first button manipulation information, and the first user condition information;
e) executing (S1030, S1140) the operation (310, 320, 330, 340, 350, 360) of the 3D slitter; and
f) executing a 3D slitter training scenario including an operation preparation training scenario based on an operation process of the 3D slitter;
g) wherein the 3D slitter performs the operation preparation training scenario where at least some of a set value, a condition value, and the quality information corresponding thereto of the SD slitter is changed to an abnormal range.

14. The slitter simulation method for secondary battery production according to claim 13, further comprising:
displaying an unwinder operation panel for determining an operation (310, 320, 330, 340, 350, 360) of an unwinder part of the 3D slitter on the facility operator input/output device; and
displaying a rewinder operation panel for determining an operation (310, 320, 330, 340, 350, 360) of a rewinder part of the 3D slitter on the facility operator input/output device.

15. The slitter simulation method for secondary battery production according to claim 13, further comprising:
executing at least one of user behavior guide display on the device operator input/output device, user condition guide display on the facility operator input/output device, or button manipulation guide display on the facility operator input/output device according to the 3D slitter training scenario;
obtaining at least one of the first user behavior information based on the user behavior guide display, the first button manipulation information based on the button manipulation guide display, or the first user condition information based on the user condition guide display; and
changing at least one of the software module device operator (130, 210) or the software module facility operator (120) based on at least one of the first user behavior information based on the user behavior guide display, the first button manipulation information based on the button manipulation guide display, or the first user condition information based on the user condition guide display.

16. A non-transitory computer-readable medium storing instructions for executing a method for secondary battery production, the instructions, when executed by one or more processors, causing the one or more processors (1310) to perform operations (310, 320, 330, 340, 350, 360) comprising:
a) executing (S1010, S1110) a software module device operator (130, 210) comprising a 3D slitter associated with secondary battery production and quality information related to quality of a material generated by the 3D slitter, wherein the 3D slitter is a virtual 3D slitter;
b) executing (S1020, S1120) a software module facility operator (120) comprising a plurality of adjustment parameters for determining an operation (310, 320, 330, 340, 350, 360) of the 3D slitter and a plurality of operation buttons for driving the 3D slitter;
c) obtaining (S1030, S1130) at least one of first user behavior information obtained through a device operator input/output device, first button manipulation information obtained through a facility operator input/output device, or first user condition information obtained through the facility operator input/output device;
d) determining (S1040, S1140) the operation (310, 320, 330, 340, 350, 360) of the 3D slitter based on at least one of the first user behavior information, the first button manipulation information, or the first user condition information;
e) executing (S1050, S1150) the operation (310, 320, 330, 340, 350, 360) of the 3D slitter; and
f) executing a 3D slitter training scenario including an operation preparation training scenario based on an operation process of the 3D slitter;
g) wherein the 3D slitter performs the operation preparation training scenario where at least some of a set value, a condition value, and the quality information corresponding thereto of the SD slitter is changed to an abnormal range.

## Patentansprüche

1. Batteriesimulationsvorrichtung zur Sekundärbatterieproduktion, umfassend:
a) einen Speicher (1320), der konfiguriert ist, um mindestens eine Anweisung zu speichern; und
b) mindestens einen Prozessor (1310), der konfiguriert ist, um die mindestens eine Anweisung, die in dem Speicher (1320) gespeichert ist, auszuführen, um Operationen (310, 320, 330, 340, 350, 360) durchzuführen, die umfassen:
c1) Ausführen (S1010, S1110) eines Softwaremoduleinrichtungsoperators (130, 210), umfassend einen 3D-Schlitzer, der mit der Sekundärbatterieproduktion assoziiert ist, und Qualitätsinformationen, die sich auf die Qualität eines Materials beziehen, das durch den 3D-Schlitzer erzeugt wird, wobei der 3D-Schlitzer ein virtuellen 3D-Schlitzer ist;
c2) Ausführen (S1010, S1110) eines Softwaremodulanlagenoperators (120), umfassend eine Vielzahl von Einstellungsparametern zum Bestimmen einer Operation (310, 320, 330, 340, 350, 360) des 3D-Schlitzers und eine Vielzahl von Operationstasten zum Ansteuern des 3D-Schlitzers;
c3) Erhalten (S1020, S1120) von mindestens einem von ersten Benutzerverhaltensinformationen, die durch eine Einrichtungsoperator-Eingabe/Ausgabeeinrichtung erhalten werden, ersten Tastenmanipulationsinformationen, die durch eine Anlagenoperator-Eingabe/Ausgabeeinrichtung erhalten werden, oder ersten Benutzerbedingungsinformationen, die durch die Anlagenoperator-Eingabe/Ausgabeeinrichtung erhalten werden;
c4) Bestimmen (S1030, S1130) der Operation (310, 320, 330, 340, 350, 360) des 3D-Schlitzers basierend auf mindestens einem von den ersten Benutzerverhaltensinformationen, den ersten Tastenmanipulationsinformationen oder den ersten Benutzerbedingungsinformationen,
c5) Ausführen (S1040, S1140) der Operation (310, 320, 330, 340, 350, 360) des 3D-Schlitzers; und
c6) Ausführen eines 3D-Schlitzertrainingsszenarios einschließlich eines Operationsvorbereitungstrainingsszenarios basierend auf einem Operationsprozess des 3D-Schlitzers;
c7) wobei der 3D-Schlitzer das Operationsvorbereitungstrainingsszenario durchführt, wobei mindestens ein Teil eines gesetzten Werts, eines Bedingungswerts und der Qualitätsinformationen, die dem 3D-Schlitzer entsprechen, in einen anormalen Bereich geändert wird.

2. Batteriesimulationsvorrichtung zur Sekundärbatterieproduktion nach Anspruch 1, wobei die Operationen ferner umfassen:
Anzeigen einer Abwickeloperationstafel zum Bestimmen einer Operation eines Abwickelteils des 3D-Schlitzers auf der Anlagenoperator-Eingabe/Ausgabeeinrichtung; und
Anzeigen einer Wiederaufwickeloperationstafel zum Bestimmen einer Operation (330, 340, 350, 360) eines Wiederaufwickelteils des 3D-Schlitzers auf der Anlagenoperator-Eingabe/Ausgabeeinrichtung.

3. Batteriesimulationsvorrichtung zur Sekundärbatterieproduktion nach Anspruch 1, wobei die Operationen ferner umfassen:
Ausführen von mindestens einem von einer Benutzerverhaltensanleitungsanzeige auf der Einrichtungsoperator-Eingabe/Ausgabeeinrichtung, einer Benutzerbedingungsanleitungsanzeige auf der Anlagenoperator-Eingabe/Ausgabeeinrichtung oder einer Tastenmanipulationsanleitungsanzeige auf der Anlagenoperator-Eingabe/Ausgabeeinrichtung gemäß dem 3D-Schlitzertrainingsszenario;
Erhalten von mindestens einem von den ersten Benutzerverhaltensinformationen basierend auf der Benutzerverhaltensanleitungsanzeige, den ersten Tastenmanipulationsinformationen basierend auf der Tastenmanipulationsanleitungsanzeige oder den ersten Benutzerbedingungsinformationen basierend auf der Benutzerbedingungsanleitungsanzeige; und
Ändern von mindestens einem von dem Softwaremoduleinrichtungsoperator (130, 210) oder dem Softwaremodulanlagenoperator (120) basierend auf mindestens einem von den ersten Benutzerverhaltensinformationen basierend auf der Benutzerverhaltensanleitungsanzeige, den ersten Tastenmanipulationsinformationen basierend auf der Tastenmanipulationsanleitungsanzeige oder den ersten Benutzerbedingungsinformationen basierend auf der Benutzerbedingungsanleitungsanzeige.

4. Batteriesimulationsvorrichtung zur Sekundärbatterieproduktion nach Anspruch 3, wobei das 3D-Schlitzertrainingsszenario ferner ein Operationstrainingsszenario oder ein Qualitätsprüfungstrainingsszenario umfasst.

5. Batteriesimulationsvorrichtung zur Sekundärbatterieproduktion nach Anspruch 4, wobei das Operationstrainingsszenario mindestens eines von einer Jumbo-Rollenladetrainingsoperation, einer Jumbo-Rollenaustauschtrainingsoperation (340), einer Schneidtrainingsoperation (340) für eine wiederaufgewickelte Rolle (720), einer Chargenendtrainingsoperation, einer Entnahmetrainingsoperation (340) für eine wiederaufgewickelte Rolle (720), einer Kernladetrainingsoperation (340) für eine wiederaufgewickelte Rolle (720) oder einer Chargenstarttrainingsoperation (340) umfasst.

6. Batteriesimulationsvorrichtung zur Sekundärbatterieproduktion nach Anspruch 4, wobei das Qualitätsprüfungstrainingsszenario mindestens eines von einer Breitenmessungstrainingsoperation (350), einer Nichtübereinstimmungsmessungstrainingsoperation (350), einer Prüfoperation (350) für eine Menge an defekten Etiketten, einer Faltniveauprüfoperation (350) oder einer Schwellniveauprüfoperation (350) umfasst.

7. Batteriesimulationsvorrichtung zur Sekundärbatterieproduktion nach Anspruch 1, wobei das Operationsvorbereitungstrainingsszenario mindestens eines von einer Inspektionstrainingsoperation (330), einer Spannungseinstellungstrainingsoperation (330), einer EPC-Einstellungstrainingsoperation (330), einer Positionseinstellungstrainingsoperation (330) für einen optischen Sensor (710), einer Einstellungstrainingsoperation (330) für eine Egalisierwalze (810) oder einer Autolabelereinstellungstrainingsoperation (330) umfasst.

8. Batteriesimulationsvorrichtung zur Sekundärbatterieproduktion nach Anspruch 7, wobei die Operationen ferner umfassen:
Bestimmen einer Trainingsoperation (330, 340, 350) der Operationsvorbereitungstrainingsszenarien des 3D-Schlitzers; und
Ändern mindestens eines von der Operation (330, 340, 350) des 3D-Schlitzers oder der Qualitätsinformationen, die sich auf die Qualität des Materials beziehen, auf einen ersten Bereich basierend auf der bestimmten Trainingsoperation.

9. Batteriesimulationsvorrichtung zur Sekundärbatterieproduktion nach Anspruch 8, wobei, wenn das bestimmte Trainingsszenario die EPC-Einstellungstrainingsoperation (330) ist,
die Operationen (330) ferner das Ändern einer Breite eines beschichteten Teils und einer Breite eines unbeschichteten Teils einer wiederaufgewickelten Rolle, die auf eine Bahn des 3D-Schlitzers gewickelt ist, so dass sie sich von vorbestimmten Spezifikationswerten unterscheiden, umfassen.

10. Batteriesimulationsvorrichtung zur Sekundärbatterieproduktion nach Anspruch 8, wobei, wenn das bestimmte Trainingsszenario die Positionseinstellungstrainingsoperation (330) für einen optischen Sensor ist,
die Operationen (330) ferner das Ändern einer Bestrahlungsposition eines optischen Sensors (710) zu einer anderen Position als einer Ausgangsposition, die in einem wiederaufgewickelten Rollenkern ausgebildet ist, der auf eine Bahn des 3D-Schlitzers gewickelt ist, umfassen.

11. Batteriesimulationsvorrichtung zur Sekundärbatterieproduktion nach Anspruch 8, wobei, wenn das bestimmte Trainingsszenario die Egalisierwalzeneinstellungstrainingsoperation (330) ist,
die Operationen (330) ferner das Ausgeben einer Schwellung auf einer Oberfläche eines Elektrodengewebes (820), das eine Egalisierwalze (810) durchlaufen hat, umfassen.

12. Batteriesimulationsvorrichtung zur Sekundärbatterieproduktion nach Anspruch 8, wobei die Operationen ferner umfassen:
Erhalten (S1210) von mindestens einem von zweiten Benutzerverhaltensinformationen, die durch die Einrichtungsoperator-Eingabe/Ausgabeeinrichtung erhalten werden, zweiten Tastenmanipulationsinformationen, die durch die Anlagenoperator-Eingabe/Ausgabeeinrichtung erhalten werden, oder zweiten Benutzerbedingungsinformationen, die durch die Anlagenoperator-Eingabe/Ausgabeeinrichtung erhalten werden; und
Ändern (S1220, S1240) mindestens eines von der Operation (360) des 3D-Schlitzers oder der Qualitätsinformationen, die sich auf die Qualität des Materials beziehen, das auf den ersten Bereich geändert wurde, auf einen zweiten Bereich basierend auf mindestens einem von den zweiten Benutzerverhaltensinformationen, den zweiten Tastenmanipulationsinformationen oder den zweiten Benutzerbedingungsinformationen.

13. Batteriesimulationsverfahren zur Sekundärbatterieproduktion, das von mindestens einem Prozessor (1310) durchgeführt wird, umfassend:
a) Ausführen (S1010, S1110) eines Softwaremoduleinrichtungsoperators (130, 210), umfassend einen 3D-Schlitzer, der mit der Sekundärbatterieproduktion assoziiert ist, und Qualitätsinformationen, die sich auf die Qualität eines Materials beziehen, das durch den 3D-Schlitzer erzeugt wird, wobei der 3D-Schlitzer ein virtueller 3D-Schlitzer ist;
b) Ausführen (S1010, S1110) eines Softwaremodulanlagenoperators (120), umfassend eine Vielzahl von Einstellungsparametern zum Bestimmen einer Operation (310, 320, 330, 340, 350, 360) des 3D-Schlitzers und eine Vielzahl von Operationstasten zum Ansteuern des 3D-Schlitzers;
c) Erhalten (S1020, S1120) von mindestens einem von ersten Benutzerverhaltensinformationen, die durch eine Einrichtungsoperator-Eingabe/Ausgabeeinrichtung erhalten werden, ersten Tastenmanipulationsinformationen, die durch eine Anlagenoperator-Eingabe/Ausgabeeinrichtung erhalten werden, oder ersten Benutzerbedingungsinformationen, die durch die Anlagenoperator-Eingabe/Ausgabeeinrichtung erhalten werden;
d) Bestimmen (S1030, S1130) der Operation (310, 320, 330, 340, 350, 360) des 3D-Schlitzers basierend auf mindestens einem von den ersten Benutzerverhaltensinformationen, den ersten Tastenmanipulationsinformationen und den ersten Benutzerbedingungsinformationen;
e) Ausführen (S1030, S1140) der Operation (310, 320, 330, 340, 350, 360) des 3D-Schlitzers; und
f) Ausführen eines 3D-Schlitzertrainingsszenarios einschließlich eines Operationsvorbereitungstrainingsszenarios basierend auf einem Operationsprozess des 3D-Schlitzers;
g) wobei der 3D-Schlitzer das Operationsvorbereitungstrainingsszenario durchführt, wobei mindestens ein Teil eines gesetzten Werts, eines Bedingungswerts und der Qualitätsinformationen, die dem SD-Schlitzer entsprechen, in einen anormalen Bereich geändert wird.

14. Batteriesimulationsverfahren zur Sekundärbatterieproduktion nach Anspruch 13, ferner umfassend:
Anzeigen einer Abwickeloperationstafel zum Bestimmen einer Operation (310, 320, 330, 340, 350, 360) eines Abwickelteils des 3D-Schlitzers auf der Anlagenoperator-Eingabe/Ausgabeeinrichtung; und
Anzeigen einer Wiederaufwickeloperationstafel zum Bestimmen einer Operation (310, 320, 330, 340, 350, 360) eines Wiederaufwickelteils des 3D-Schlitzers auf der Anlagenoperator-Eingabe/Ausgabeeinrichtung.

15. Batteriesimulationsverfahren zur Sekundärbatterieproduktion nach Anspruch 13, ferner umfassend:
Ausführen von mindestens einem von einer Benutzerverhaltensanleitungsanzeige auf der Einrichtungsoperator-Eingabe/Ausgabeeinrichtung, einer Benutzerbedingungsanleitungsanzeige auf der Anlagenoperator-Eingabe/Ausgabeeinrichtung oder einer Tastenmanipulationsanleitungsanzeige auf der Anlagenoperator-Eingabe/Ausgabeeinrichtung gemäß dem 3D-Schlitzertrainingsszenario;
Erhalten von mindestens einem von den ersten Benutzerverhaltensinformationen basierend auf der Benutzerverhaltensanleitungsanzeige, den ersten Tastenmanipulationsinformationen basierend auf der Tastenmanipulationsanleitungsanzeige oder den ersten Benutzerbedingungsinformationen basierend auf der Benutzerbedingungsanleitungsanzeige; und
Ändern von mindestens einem von dem Softwaremoduleinrichtungsoperator (130, 210) oder dem Softwaremodulanlagenoperator (120) basierend auf mindestens einem von den ersten Benutzerverhaltensinformationen basierend auf der Benutzerverhaltensanleitungsanzeige, den ersten Tastenmanipulationsinformationen basierend auf der Tastenmanipulationsanleitungsanzeige oder den ersten Benutzerbedingungsinformationen basierend auf der Benutzerbedingungsanleitungsanzeige.

16. Nichtflüchtiges computerlesbares Medium, das Anweisungen zum Ausführen eines Verfahrens zur Sekundärbatterieproduktion speichert, wobei die Anweisungen, wenn sie von einem oder mehreren Prozessoren ausgeführt werden, bewirken, dass der eine oder die mehreren Prozessoren (1310) Operationen (310, 320, 330, 340, 350, 360) durchführen, die umfassen:
a) Ausführen (S1010, S1110) eines Softwaremoduleinrichtungsoperators (130, 210), umfassend einen 3D-Schlitzer, der mit der Sekundärbatterieproduktion assoziiert ist, und Qualitätsinformationen, die sich auf die Qualität eines Materials beziehen, das durch den 3D-Schlitzer erzeugt wird, wobei der 3D-Schlitzer ein virtueller 3D-Schlitzer ist;
b) Ausführen (S1020, S1120) eines Softwaremodulanlagenoperators (120), umfassend eine Vielzahl von Einstellungsparametern zum Bestimmen einer Operation (310, 320, 330, 340, 350, 360) des 3D-Schlitzers und eine Vielzahl von Operationstasten zum Ansteuern des 3D-Schlitzers;
c) Erhalten (S1030, S1130) von mindestens einem von ersten Benutzerverhaltensinformationen, die durch eine Einrichtungsoperator-Eingabe/Ausgabeeinrichtung erhalten werden, ersten Tastenmanipulationsinformationen, die durch eine Anlagenoperator-Eingabe/Ausgabeeinrichtung erhalten werden, oder ersten Benutzerbedingungsinformationen, die durch die Anlagenoperator-Eingabe/Ausgabeeinrichtung erhalten werden;
d) Bestimmen (S1040, S1140) der Operation (310, 320, 330, 340, 350, 360) des 3D-Schlitzers basierend auf mindestens einem von den ersten Benutzerverhaltensinformationen, den ersten Tastenmanipulationsinformationen oder den ersten Benutzerbedingungsinformationen;
e) Ausführen (S1050, S1150) der Operation (310, 320, 330, 340, 350, 360) des 3D-Schlitzers; und
f) Ausführen eines 3D-Schlitzertrainingsszenarios einschließlich eines Operationsvorbereitungstrainingsszenarios basierend auf einem Operationsprozess des 3D-Schlitzers;
g) wobei der 3D-Schlitzer das Operationsvorbereitungstrainingsszenario durchführt, wobei mindestens ein Teil eines gesetzten Werts, eines Bedingungswerts und der Qualitätsinformationen, die dem SD-Schlitzer entsprechen, in einen anormalen Bereich geändert wird.

## Revendications

1. Dispositif de simulation de refendeuse pour la production de batteries secondaires, comprenant :
a) une mémoire (1320) configurée pour stocker au moins une instruction ; et
b) au moins un processeur (1310) configuré pour exécuter ladite au moins une instruction stockée en mémoire (1320) afin d'effectuer des opérations (310, 320, 330, 340, 350, 360) comprenant :
c1) l'exécution (S1010, S1110) d'un opérateur de dispositif à module logiciel (130, 210) comprenant une refendeuse 3D associée à la production de batteries secondaires et des informations de qualité relatives à la qualité d'un matériel généré par la refendeuse 3D, ladite refendeuse 3D étant une refendeuse 3D virtuelle ;
c2) l'exécution (S1010, S1110) d'un opérateur d'installation à module logiciel (120) comprenant une pluralité de paramètres de réglage pour déterminer une opération (310, 320, 330, 340, 350, 360) de la refendeuse 3D et une pluralité de boutons de commande pour commander la refendeuse 3D ;
c3) l'obtention (S1020, S1120) de premières informations de comportement d'utilisateur obtenues par un dispositif d'entrée/de sortie d'opérateur de dispositif, et/ou de premières informations de manipulation de bouton obtenues par un dispositif d'entrée/de sortie d'opérateur d'installation, et/ou de premières informations d'état d'utilisateur obtenues par le dispositif d'entrée/de sortie d'opérateur d'installation ;
c4) la détermination (S1030, S1130) de l'opération (310, 320, 330, 340, 350, 360) de la refendeuse 3D sur la base des premières informations de comportement d'utilisateur et/ou des premières informations de manipulation de bouton et/ou des premières informations d'état d'utilisateur ;
c5) l'exécution (S1040, S1140) de l'opération (310, 320, 330, 340, 350, 360) de la refendeuse 3D ; et
c6) l'exécution d'un scénario d'apprentissage de refendeuse 3D comprenant un scénario d'apprentissage de préparation d'opération sur la base d'un processus d'actionnement de la refendeuse 3D ;
c7) où la refendeuse 3D exécute le scénario d'apprentissage de préparation d'opération, au moins une partie d'une valeur définie, d'une valeur d'état et des informations de qualité correspondantes de la refendeuse 3D étant modifiée vers une plage anormale.

2. Dispositif de simulation de refendeuse pour la production de batteries secondaires selon la revendication 1, où les opérations comprennent en outre :
l'affichage d'un panneau de commande de dérouleur pour déterminer une opération d'une partie de dérouleur de la refendeuse 3D sur le dispositif d'entrée/de sortie de l'opérateur d'installation ; et
l'affichage d'un panneau de commande d'enrouleur pour déterminer une opération (330, 340, 350, 360) d'une partie d'enrouleur de la refendeuse 3D sur le dispositif d'entrée/de sortie de l'opérateur d'installation.

3. Dispositif de simulation de refendeuse pour la production de batteries secondaires selon la revendication 1, où les opérations comprennent en outre :
l'exécution d'au moins un des affichages suivants : affichage d'un guide de comportement d'utilisateur sur le dispositif d'entrée/de sortie d'opérateur de dispositif, affichage d'un guide d'état d'utilisateur sur le dispositif d'entrée/de sortie d'opérateur d'installation, ou affichage d'un guide de manipulation de bouton sur le dispositif d'entrée/de sortie d'opérateur d'installation en fonction du scénario d'apprentissage de refendeuse 3D ;
l'obtention des premières informations de comportement d'utilisateur sur la base de l'affichage du guide de comportement d'utilisateur et/ou des premières informations de manipulation de bouton sur la base de l'affichage du guide de manipulation de bouton et/ou des premières informations d'état d'utilisateur sur la base de l'affichage du guide d'état d'utilisateur ; et
la modification de l'opérateur de dispositif à module logiciel (130, 210) et/ou de l'opérateur d'installation à module logiciel (120) sur la base des premières informations de comportement d'utilisateur à partir de l'affichage du guide de comportement d'utilisateur et/ou des premières informations de manipulation de bouton à partir du guide de manipulation de bouton et/ou des premières informations d'état d'utilisateur à partir de l'affichage du guide d'état d'utilisateur.

4. Dispositif de simulation de refendeuse pour la production de batteries secondaires selon la revendication 3, où le scénario d'apprentissage de refendeuse 3D comprend en outre un scénario d'apprentissage opérationnel ou un scénario d'apprentissage de contrôle de qualité.

5. Dispositif de simulation de refendeuse pour la production de batteries secondaires selon la revendication 4, où le scénario d'apprentissage opérationnel comprend au moins une opération d'apprentissage entre une opération d'apprentissage de chargement de rouleau jumbo, une opération d'apprentissage de remplacement de rouleau jumbo (340), une opération d'apprentissage (340) de découpe de rouleau rembobiné (720), une opération d'apprentissage de fin de lot, une opération d'apprentissage (340) d'extraction de rouleau rembobiné (720), une opération d'apprentissage (340) de chargement de mandrin de rouleau rembobiné (720), ou une opération d'apprentissage (340) de début de lot.

6. Dispositif de simulation de refendeuse pour la production de batteries secondaires selon la revendication 4, où le scénario d'apprentissage de contrôle de qualité comprend au moins une opération entre une opération d'apprentissage de mesure de largeur (350), une opération d'apprentissage de mesure de décalage (350), une opération de contrôle de quantité d'étiquettes défectueuses (350), une opération de contrôle de niveau de pliage (350) et une opération de contrôle de niveau de renflement (350).

7. Dispositif de simulation de refendeuse pour la production de batteries secondaires selon la revendication 1, où le scénario d'apprentissage de préparation d'opération comprend au moins une opération entre une opération d'apprentissage (330) d'inspection, une opération d'apprentissage (330) de réglage de tension, une opération d'apprentissage (330) de réglage EPC, une opération d'apprentissage (330) de réglage d'emplacement de capteur optique (710), une opération d'apprentissage (330) de réglage de rouleau de planage (810) et une opération d'apprentissage (330) de réglage d'étiqueteuse automatique.

8. Dispositif de simulation de refendeuse pour la production de batteries secondaires selon la revendication 7, où les opérations comprennent en outre :
la détermination d'une opération d'apprentissage (330, 340, 350) des scénarios d'apprentissage de préparation d'opération de la refendeuse 3D ; et
la modification de l'opération (330, 340, 350) de la refendeuse 3D et/ou des informations de qualité relatives à la qualité du matériel vers une première plage sur la base de l'opération d'apprentissage déterminée.

9. Dispositif de simulation de refendeuse pour la production de batteries secondaires selon la revendication 8, où, si le scénario d'apprentissage déterminé est l'opération d'apprentissage de réglage EPC (330),
les opérations (330) comprennent en outre la modification de largeur de pièce revêtue et de largeur de pièce non revêtue d'un rouleau rembobiné enroulé sur une ligne de la refendeuse 3D pour les différencier de valeurs de spécification prédéterminées.

10. Dispositif de simulation de refendeuse pour la production de batteries secondaires selon la revendication 8, où, si le scénario d'apprentissage déterminé est l'opération d'apprentissage de réglage d'emplacement de capteur optique (330),
les opérations (330) comprennent en outre la modification d'un emplacement d'irradiation d'un capteur optique (710) vers un emplacement autre qu'un emplacement initial formé dans un mandrin de rouleau rembobiné enroulé sur une ligne de la refendeuse 3D.

11. Dispositif de simulation de refendeuse pour la production de batteries secondaires selon la revendication 8, où, si le scénario d'apprentissage déterminé est l'opération d'apprentissage de réglage de rouleau de planage (330),
les opérations (330) comprennent en outre la production d'un renflement sur une surface d'un tissu d'électrode (820) passé par un rouleau de planage (810).

12. Dispositif de simulation de refendeuse pour la production de batteries secondaires selon la revendication 8, où les opérations comprennent en outre :
l'obtention (S1210) de deuxièmes informations de comportement d'utilisateur obtenues par le dispositif d'entrée/de sortie d'opérateur d'installation et/ou de deuxièmes informations de manipulation de bouton obtenues par le dispositif d'entrée/de sortie d'opérateur d'installation et/ou de deuxièmes informations d'état d'utilisateur obtenus par le dispositif d'entrée/de sortie de l'opérateur d'installation ; et
la modification de l'opération (360) de la refendeuse 3D et/ou des informations de qualité relatives à la qualité du matériel modifiées en première plage vers une deuxième plage sur la base des deuxièmes informations de comportement d'utilisateur et/ou des deuxièmes informations de manipulation de bouton et/ou des deuxièmes informations d'état d'utilisateur.

13. Procédé de simulation de refendeuse pour la production de batteries secondaires exécuté par au moins un processeur (1310), comprenant :
a) l'exécution (S1010, S1110) d'un opérateur de dispositif à module logiciel (130, 210) comprenant une refendeuse 3D associée à la production de batteries secondaires et des informations de qualité relatives à la qualité d'un matériel généré par la refendeuse 3D, ladite refendeuse 3D étant une refendeuse 3D virtuelle ;
b) l'exécution (S1010, S1110) d'un opérateur d'installation à module logiciel (120) comprenant une pluralité de paramètres de réglage pour déterminer une opération (310, 320, 330, 340, 350, 360) de la refendeuse 3D et une pluralité de boutons de commande pour commander la refendeuse 3D ;
c) l'obtention (S1020, S1120) de premières informations de comportement d'utilisateur obtenues par un dispositif d'entrée/de sortie d'opérateur de dispositif, et/ou de premières informations de manipulation de bouton obtenues par un dispositif d'entrée/de sortie d'opérateur d'installation, et/ou de premières informations d'état d'utilisateur obtenues par le dispositif d'entrée/de sortie d'opérateur d'installation ;
d) la détermination (S1030, S1130) de l'opération (310, 320, 330, 340, 350, 360) de la refendeuse 3D sur la base des premières informations de comportement d'utilisateur et/ou des premières informations de manipulation de bouton et/ou des premières informations d'état d'utilisateur ;
e) l'exécution (S1030, S1140) de l'opération (310, 320, 330, 340, 350, 360) de la refendeuse 3D ; et
f) l'exécution d'un scénario d'apprentissage de refendeuse 3D comprenant un scénario d'apprentissage de préparation d'opération sur la base d'un processus d'actionnement de la refendeuse 3D ;
g) où la refendeuse 3D exécute le scénario d'apprentissage de préparation d'opération, au moins une partie d'une valeur définie, d'une valeur d'état et des informations de qualité correspondantes de la refendeuse 3D étant modifiée vers une plage anormale.

14. Procédé de simulation de refendeuse pour la production de batteries secondaires selon la revendication 13, comprenant en outre :
l'affichage d'un panneau de commande de dérouleur pour déterminer une opération (310, 320, 330, 340, 350, 360) d'une partie de dérouleur de la refendeuse 3D sur le dispositif d'entrée/de sortie de l'opérateur d'installation ; et
l'affichage d'un panneau de commande d'enrouleur pour déterminer une opération (330, 340, 350, 360) d'une partie d'enrouleur de la refendeuse 3D sur le dispositif d'entrée/de sortie de l'opérateur d'installation.

15. Procédé de simulation de refendeuse pour la production de batteries secondaires selon la revendication 13, comprenant en outre :
l'exécution d'au moins un des affichages suivants : affichage d'un guide de comportement d'utilisateur sur le dispositif d'entrée/de sortie d'opérateur de dispositif, affichage d'un guide d'état d'utilisateur sur le dispositif d'entrée/de sortie d'opérateur d'installation, ou affichage d'un guide de manipulation de bouton sur le dispositif d'entrée/de sortie d'opérateur d'installation en fonction du scénario d'apprentissage de refendeuse 3D ;
l'obtention des premières informations de comportement d'utilisateur sur la base de l'affichage du guide de comportement d'utilisateur et/ou des premières informations de manipulation de bouton sur la base de l'affichage du guide de manipulation de bouton et/ou des premières informations d'état d'utilisateur sur la base de l'affichage du guide d'état d'utilisateur ; et
la modification de l'opérateur de dispositif à module logiciel (130, 210) et/ou de l'opérateur d'installation à module logiciel (120) sur la base des premières informations de comportement d'utilisateur à partir de l'affichage du guide de comportement d'utilisateur et/ou des premières informations de manipulation de bouton à partir du guide de manipulation de bouton et/ou des premières informations d'état d'utilisateur à partir de l'affichage du guide d'état d'utilisateur.

16. Support non transitoire lisible par ordinateur stockant des instructions pour la mise en œuvre d'un procédé de production de batteries secondaires, dont l'exécution par un ou plusieurs processeurs entraîne l'exécution par le ou les processeurs (1310) d'opérations (310, 320, 330, 340, 350, 360) comprenant :
a) l'exécution (S1010, S1110) d'un opérateur de dispositif à module logiciel (130, 210) comprenant une refendeuse 3D associée à la production de batteries secondaires et des informations de qualité relatives à la qualité d'un matériel généré par la refendeuse 3D, ladite refendeuse 3D étant une refendeuse 3D virtuelle ;
b) l'exécution (S1020, S1120) d'un opérateur d'installation à module logiciel (120) comprenant une pluralité de paramètres de réglage pour déterminer une opération (310, 320, 330, 340, 350, 360) de la refendeuse 3D et une pluralité de boutons de commande pour commander la refendeuse 3D ;
c) l'obtention (S1030, S1130) de premières informations de comportement d'utilisateur obtenues par un dispositif d'entrée/de sortie d'opérateur de dispositif, et/ou de premières informations de manipulation de bouton obtenues par un dispositif d'entrée/de sortie d'opérateur d'installation, et/ou de premières informations d'état d'utilisateur obtenues par le dispositif d'entrée/de sortie d'opérateur d'installation ;
d) la détermination (S1040, S1140) de l'opération (310, 320, 330, 340, 350, 360) de la refendeuse 3D sur la base des premières informations de comportement d'utilisateur et/ou des premières informations de manipulation de bouton et/ou des premières informations d'état d'utilisateur ;
e) l'exécution (S1030, S1140) de l'opération (310, 320, 330, 340, 350, 360) de la refendeuse 3D ; et
f) l'exécution d'un scénario d'apprentissage de refendeuse 3D comprenant un scénario d'apprentissage de préparation d'opération sur la base d'un processus d'actionnement de la refendeuse 3D ;
g) où la refendeuse 3D exécute le scénario d'apprentissage de préparation d'opération, au moins une partie d'une valeur définie, d'une valeur d'état et des informations de qualité correspondantes de la refendeuse 3D étant modifiée vers une plage anormale.
